# EUROPEAN PATENT APPLICATION

(11) **EP 4 764 572 A1**
(43) Date of publication of application: **24.06.2026**
(21) Application number: 24856699.4
(22) Date of filing: 02.08.2024
(51) Int. Cl.: G01R 31/52, G01R 31/08, H02H 3/08, H02H 3/04, H02H 3/16, G01R 19/165, G01R 19/30, G01R 19/00, G01R 19/10, G08C 19/02

(54) **ABNORMAL CURRENT DETECTION APPARATUS AND CONTROL METHOD THEREOF**

(30) Priority: 18.08.2023 KR 20230108344; 18.08.2023 KR 20230108345
(71) Applicant: LS Electric Co., Ltd., Anyang-si, Gyeonggi-do 14119 (KR)
(72) Inventor: YUN, Dongjin, Anyang-si Gyeonggi-do 14118 (KR); KIM, Seongeon, Anyang-si Gyeonggi-do 14118 (KR)
(74) Representative: K&L Gates LLP
(86) International application number: PCT/KR2024/011429
(87) International publication number: WO 2025/042086

(57) **Abstract**

The present invention relates to an abnormal current detection apparatus comprising: a semiconductor switch connected to one of a plurality of power lines connecting a power system and a power device, so as to enable the power system to be connected to the power device; a gate driver for applying a gate voltage to the semiconductor switch; and a control unit for determining whether a ground fault current exists on the basis of a current flowing into the semiconductor switch between the connected power system and power device, controlling the gate driver to disconnect the power device from the power system on the basis of a determination result, controlling, when the power device is disconnected from the power system, the gate driver at preconfigured regular time intervals to re-determine whether a ground fault current exists on the basis of the current flowing into the semiconductor switch, and controlling the gate driver to re-disconnect or maintain a connected state, on the basis of a re-determination result.

## Description

### Technical Field

The disclosure relates to an abnormal current detection apparatus that detects abnormal currents, such as ground fault currents.

### Background Art

Early detection of ground faults in power systems is crucial for both economic and safety reasons, as it suppresses potential future hazards and ensures that critical systems remain online. Therefore, technologies for detecting ground faults have been continuously studied, and as part of these studies, various ground fault detectors have emerged.

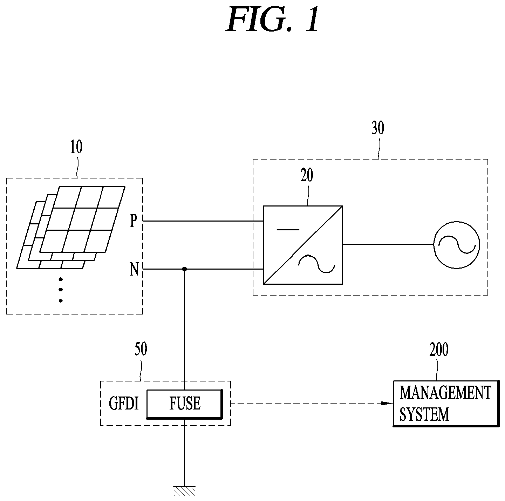

As a representative ground fault detector, there is a ground fault detection indicator (GFDI) 50, as shown in FIG. 1. The GFDI 50 may be configured to include a fuse and may be connected to a power device 10 connected to a power system 30. For example, in case that the power system 30 includes renewable energy generation devices, such as solar or geothermal power generation devices, each of renewable energy generation devices may be the power device 10 connected to the power system, and the GFDI 50 may be arranged in the renewable energy generation device to determine whether a ground fault has occurred.

Meanwhile, the GFDI 50 opens a circuit as the fuse blows due to overcurrent, such as leakage current, caused by a ground fault. For example, the GFDI 50 may be arranged on a circuit which connects the renewable energy generation device to the power system 30. When a ground fault occurs in the power device 10, for example, the renewable energy power generation device, the fuse of the GFDI 50 blows due to overcurrent generated by the ground fault, thereby opening the circuit connecting the power device 10 and the power system 30. Accordingly, the power device 10 in which the ground fault has occurred may be cut off from the power system 30.

However, as described above, the GFDI 50 may detect a ground fault when the circuit is open due to the blowing of the fuse arranged in the device. However, the blowing of the fuse is an irreversible change. As a result, a problem arises in that the circuit remains open, namely, the power device 10 is kept disconnected from the power system 10, until the blown fuse is replaced, even if the ground fault in the power device 10 has been repaired.

In this way, the power device 10 stays disconnected until the fuse is replaced regardless of whether the ground fault has been repaired, which causes a problem that it is difficult for an operator to recognize whether a ground fault occurred in the power device 10 connected to the GFDI 50, which the operator is working on, has been repaired or not. Further, the GFDI 50 detects whether a ground fault has occurred based on the blowing of the fuse, which causes a problem that the blown fuse, i.e., the GFDI 50, must be replaced to reconnect the cut-off power device 10 to the power system 30. That is, in case that the GFDI 50 is not replaced even if the ground fault has been repaired, the power device 10 remains in the cut-off state, which arises a problem that a time for which the power device 10 is unnecessarily cut off becomes longer until the GFDI 50 is replaced.

Meanwhile, in case that the ground fault in the power device 10 is repaired, a ground fault current may not occur when the circuit is reconnected by replacing the GFDI 50. However, in case that the power device is reconnected to the power system by replacing the GFDI while the ground fault remains unsolved, there is a risk of electric shock as the operator may be exposed to the ground fault current.

As the GFDI 50 utilizes the characteristic that the fuse blows due to overcurrent, as described above, the GFDI 50 can detect a ground fault only when the overcurrent caused due to the ground fault has a predetermined magnitude or more. That is, in case that overcurrent caused by a ground fault is less than a minimum current that causes blowing of a fuse (e.g., a line in which a microcurrent flows), there is a problem in that it is difficult to detect the ground fault. Or, in case that a current that normally flows between the power device 10 and the power system 30 is higher than or equal to a current causing the blowing of the fuse, it is difficult to detect the ground fault by using the GFDI 50.

### Disclosure of Invention

### Technical Problem

The disclosure aims to solve the above-mentioned problems and other problems, and an aspect of the disclosure is to provide an abnormal current detection apparatus, which detects whether a detected abnormal state, such as a ground fault or short-circuit, has been repaired upon detecting an abnormal current due to the abnormal state, and allows an operator to easily check whether the abnormal state has been repaired, and a control method thereof.

Another aspect of the disclosure is to provide an abnormal current detection apparatus, which is capable of suppressing a power device from being unnecessarily disconnected even though the power device in which a ground fault was detected has been repaired, and a control method thereof.

Another aspect of the disclosure is to provide an abnormal current detection apparatus, which is capable of easily detecting whether a ground fault has occurred even when a current normally flowing between a microcircuit or power device 10, in which a ground fault current is less than a fuse blowing current upon an occurrence of a ground fault, and a power system 30 is higher than or equal to the fuse blowing current, and a control method thereof.

### Solution to problem

In order to achieve the above or other purposes, according to one aspect of the disclosure, there is provided an abnormal current detection apparatus according to an embodiment of the disclosure including a semiconductor switch connected to any one of a plurality of lines connecting a power system and a power device, such that the power system is connected to the power device, a gate driver configured to apply a gate voltage to the semiconductor switch, and a controller configured to determine whether a ground fault current exists based on a current flowing into the semiconductor switch between the connected power system and power device, and control the gate driver to disconnect the power device from the power system according to a result of the determination, wherein when the power device is disconnected from the power system, the controller redetermines whether the ground fault current exists based on the current flowing into the semiconductor switch by controlling the gate driver such that the power device is connected to the power system at a preset time interval, and controls the gate driver, according to a result of the redetermination, to disconnect the power device from the power system again or maintain the connected state between the power device and the power system.

In an embodiment, the one of the plurality of lines is a neutral line connecting the power device and the power system, the neutral line is connected to ground, and a source terminal of the semiconductor switch is connected to the neutral line and a drain terminal of the semiconductor switch is connected to the ground.

In an embodiment, when the power device is disconnected from the power system, the controller redetermines whether the ground fault current exists by applying a gate voltage of a limited level to a gate terminal of the semiconductor switch at the preset time interval and temporarily connects the source terminal and the drain terminal, and restores the gate voltage of the limited level when a ground fault current does not exist as a result of the redetermination.

In an embodiment, the gate voltage of the limited level is a voltage higher than or equal to a threshold voltage at which the source terminal and the drain terminal of the semiconductor switch are electrically connectable to each other, and a voltage of a level lower than a level of the restored gate voltage.

In an embodiment, a management system which is connected to the abnormal current detection apparatus to perform communication transmits a reference current, for the abnormal current detection apparatus to redetermine whether the ground fault current exist, to the abnormal current detection apparatus based on a detection result of the ground fault current and ground fault detection information including information related to a power device in which the ground fault current has been detected, and the abnormal current detection apparatus redetermines whether the ground fault current exists, based on a result of comparing a result of detecting the current, flowing to the semiconductor switch from the power device and the power system connected at the preset time interval, and the reference current.

In an embodiment, the controller compares a result of analyzing characteristics of the current flowing into the semiconductor switch with abnormal current characteristics according to a preset abnormal current profile, and determines or redetermines whether the ground fault current exists according to a result of determining whether current characteristics analyzed by a result of the comparison match the abnormal current characteristics, and the abnormal current profile includes at least one of a change in current magnitude over time, an average current magnitude, and a difference between a maximum current value and a minimum current value, and is provided from the management system.

In order to achieve the above or other purposes, according to one aspect of the disclosure, there is provided a method of controlling an abnormal current detection apparatus including a semiconductor switch connected to one of a plurality of lines connecting a power system and a power device, the method including controlling the semiconductor switch to connect the power device to the power system, detecting a current flowing between the connected power device and power system and primarily determining whether a ground fault current exists based on a preset ground fault detection current, controlling the semiconductor switch to disconnect the power device from the power system according to a result of the primary determination, checking whether a preset time has elapsed, controlling the semiconductor switch to reconnect the power device to the power system when the preset time has elapsed as a result of the check, detecting a current flowing between the reconnected power device and power system and secondarily determining whether the ground fault current exists based on a preset reference current, and re-performing the check of whether the preset time has elapsed through the secondary determination, or maintaining a state where the power device is connected to the power system, according to a result of the secondary determination.

In an embodiment, the one of the plurality of lines is a neutral line connecting the power device and the power system, the neutral line is connected to ground, and a source terminal of the semiconductor switch is connected to the neutral line and a drain terminal of the semiconductor switch is connected to the ground, the controlling the semiconductor switch to connect the power device to the power system is a step of applying a first gate voltage higher than or equal to a preset threshold voltage to a gate terminal of the semiconductor switch so that the source terminal and the drain terminal of the semiconductor switch are electrically connected, and the controlling the semiconductor switch to reconnect the power device to the power system is a step of applying a second gate voltage, which is higher than or equal to the threshold voltage and lower than the first gate voltage, to the gate terminal of the semiconductor switch.

In order to achieve the above or other purposes, according to one aspect of the disclosure, there is provided an abnormal current detection apparatus including a current detection unit arranged on one of a plurality of lines connecting a power system and a power device so as to connect the power system and the power device, and configured to detect whether an abnormal current exists based on preset detection information, and to disconnect the power device from the power system according to a result of the detection of whether the abnormal current exists, a semiconductor switch connected to the current detection unit to form a bypass path bypassing the current detection unit, and including a gate driver configured to apply a gate voltage for controlling a first terminal and a second terminal, connected to a first pole and a second pole of the current detection unit, respectively, for forming the bypass path, to be electrically connected or electrically disconnected, and a controller configured to control the first terminal and the second terminal to be electrically connected when the power device is disconnected from the power system according to whether the current detection unit has detected an abnormal current, determine whether the abnormal current exists based on a current flowing along the bypass path through the connected first terminal and second terminal, and control the semiconductor switch to cut off the bypass path or maintain the connection between the power system and the power device through the bypass path according to a result of the determination.

In an embodiment, the current detection unit is a ground fault detection indicator (GFDI) comprising a fuse that blows when an overcurrent higher than or equal to a preset blowing current is introduced, and the fuse is connected between ground and a neutral line among the plurality of lines connecting the power system and the power device.

In an embodiment, a first pole of the fuse is connected to the neutral wire, and a second pole of the fuse is connected to the ground, and the first terminal of the semiconductor switch is connected between the first pole of the fuse and the neutral line, and the second terminal of the semiconductor switch is connected between the second pole of the fuse and the ground.

In an embodiment, the controller activates the semiconductor switch in an inactive state in conjunction with blowing of the fuse, and the controller switches the semiconductor switch in an active state into the inactive state when the blown fuse is replaced and the first and second poles of the fuse are electrically connected.

In an embodiment, the controller controls the semiconductor switch to apply a first gate voltage exceeding a preset threshold voltage so as to form a first bypass path, and determines whether the abnormal current exists through the formed first bypass path, and when a result of the determination shows that no abnormal current exists, controls the semiconductor switch to apply a second gate voltage higher than the first gate voltage, so as to form a second bypass path for maintaining the connection between the power system and the power device.

In order to achieve the above or other purposes, according to one aspect of the disclosure, there is provided an abnormal current detection apparatus including a current detection unit configured to connect ground and a neutral line among lines connecting a power system and a power device, detect an abnormal current flowing in the neutral line, and disconnect the power device from the power system when the abnormal current is detected, a semiconductor circuit breaker (solid state circuit breaker (SSCB)) including a semiconductor switch connected to the current detection unit to receive a result of the abnormal current detection provided from the current detection unit, and configured to form a bypass path connecting the neutral line and the ground by bypassing the current detection unit when an abnormal current is detected from the current detection unit and thereby the power device is disconnected from the power system, and a controller configured to determining whether the abnormal current flows on the neutral line based on a current flowing in the bypass path, and control the semiconductor switch to cut off the bypass path or maintain the connection between the neutral line and the ground through the bypass path according to a result of the determination.

In an embodiment, the current detection unit is a ground fault detection indicator (GFDI) including a fuse that blows when an abnormal current exceeding a preset blowing current is detected, the GFDI transmits abnormal current detection information to a management system and the semiconductor circuit breaker according to blowing of the fuse, and the semiconductor circuit breaker is switched from an inactive state to an active state when the abnormal current detection information is received.

In an embodiment, the GFDI transmits a deactivation signal to the semiconductor circuit breaker when the neutral line and the ground are connected through the fuse as the blown fuse is replaced, and the semiconductor circuit breaker is switched from the active state to the inactive state when the deactivation signal is received, and transmits information indicating that the power device has been normally connected to the management system.

### Advantageous Effects of Invention

According to at least one of embodiments of the disclosure, whether a power device in which a ground fault detected therein has been repaired can be automatically detected, and whether the power device is normally connected can be displayed according to a result of the detection, such that an operator can easily identify the power device in which the ground fault has been repaired and other power devices in which the ground fault has not been repaired, which can suppress the operator from working on the power devices in which the ground fault has not been repaired, thereby suppressing safety accidents of the operator.

When the ground fault is repaired, a circuit between the power device and the power system can be closed, thereby obtaining an effect of reducing a time for which the power device is unnecessarily cut off.

A ground fault detection current can be freely set by detecting a ground fault using a semiconductor circuit breaker. Accordingly, there is an advantage in that whether a ground fault has occurred can be easily detected when a microcurrent that is difficult to be detected as a ground fault current by an existing fuse, or when a current higher than or equal to a fuse blowing current flows.

According to at least one of embodiments of the disclosure, whether a power device in which an abnormal state was detected has been repaired can be automatically detected, and whether an abnormal current is flowing from the power device in which the abnormal state has been detected can be displayed according to a result of the detection, such that an operator can easily identify the power device in which the abnormal state has occurred and other power devices in which the abnormal state has not occurred, which can suppress a repair work on the power devices in which the abnormal state has not been repaired, thereby suppressing safety accidents of the operator.

When an abnormal state is repaired, a power device can be connected to a power system through a bypass path even though a fuse of a GFDI has blown, which can reduce a time for which the completely repaired power device is unnecessarily disconnected from the power system.

### Brief Description of Drawings

FIG. 1 is a block diagram of a structure in which a GFDI is connected between a power device and a power system.
FIG. 2 is a block diagram of an abnormal current detection apparatus according to an embodiment of the disclosure that detects a ground fault using a semiconductor circuit breaker.
FIG. 3 is a flowchart of an operation process of an abnormal current detection apparatus according to an embodiment of the disclosure to detect a ground fault and determine whether a ground fault exists.
FIG. 4 is a flowchart of an operation process of a management system according to ground fault detection when a reference current is set according to the control of the management system.
FIG. 5 is a flowchart of an operation process of an abnormal current detection apparatus according to an embodiment of the disclosure to detect a ground fault based on an abnormal current detection result.
FIG. 6 is a view of an example of abnormal current detection apparatuses according to an embodiment, which are arranged between the plurality of power devices and a power system when the plurality of power devices are connected to the power system.
FIG. 7 is a block diagram of a structure of an abnormal current detection apparatus having a semiconductor circuit breaker according to an embodiment of the disclosure.
FIG. 8 is a flowchart of an operation process of an abnormal current detection apparatus according to an embodiment of the disclosure to detect a ground fault and determine whether a ground fault exists.
FIG. 9 is a more detailed flowchart of the process of determining whether an abnormal current has been detected during the operation process of FIG. 2.
FIG. 10 is a view of an example of a power system connected to a plurality of power devices, and abnormal current detection apparatuses according to an embodiment, which are arranged between the plurality of power devices and the power system.

### Mode for the Invention

It is noted that the technical terms used herein are used only to describe specific embodiments and are not intended to limit the invention. The singular forms are intended to include the plural forms as well, unless the context clearly indicates otherwise. In this specification, the terms "comprising" and "including" should not be construed to necessarily include all of the elements or steps disclosed herein, and should be construed not to include some of the elements or steps thereof, or should be construed to further include additional elements or steps.

In describing the technology disclosed in this specification, if a detailed explanation for a related known function or construction is considered to unnecessarily divert the gist of the disclosure, such explanation has been omitted but would be understood by those skilled in the art.

First, explaining the gist of the disclosure, to solve the problem of the related art GFDI, that is, the problem that an operator cannot recognize whether or not a ground fault has occurred in a power device connected to the GFDI, which he or she is working on, because a circuit remains open regardless of whether a ground fault has been repaired when the ground fault is detected, an abnormal current detection apparatus according to an embodiment of the disclosure is configured to detect whether a ground fault has occurred and whether a power device is normally connected by using a solid state circuit breaker (SSCB), which uses a semiconductor switch capable of fast cutting off the power device from a power system when the ground fault is detected.

Hereinafter, embodiments disclosed herein will be described in detail with reference to the accompanying drawings.

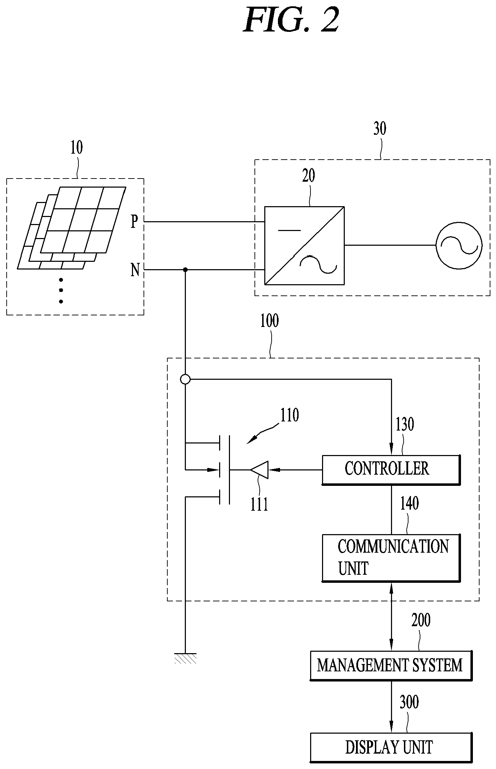

FIG. 2 is a block diagram of an abnormal current detection apparatus according to an embodiment of the disclosure that detects a ground fault using a semiconductor circuit breaker.

Referring to FIG. 2, first, a power device 10 may be connected to a power system 30. The power device 10 may be a renewable energy generation device, such as a solar power generation device. In this case, direct-current electric energy generated in the renewable energy generation device may be converted into alternating-current electricity through a converter 20 and supplied to the power system 30. Here, the power system 30 may be a storage device that stores the generated electric energy, or a system including an energy supply network, such as a grid, which supplies electric energy to a plurality of demand sources.

When the power device 10 is connected to the power system 30, an abnormal current detection apparatus 100 according to an embodiment of the disclosure may be connected between the power device 10 and the power system 30. Here, when the power device 10 is a power generation device capable of generating electricity as shown in FIG. 2, the power device 10 may configure a circuit which is connected to a positive (P) phase line, which is a path through which the electric energy generated by the power device 10 is input to the power system 30, and an neutral (N) phase line, which is a path through which a current returns. The P line may be referred to as a live line or hot line, and the N line may be referred to as a neutral line.

As shown in FIG. 2, when the power system 30 includes the converter 20, the abnormal current detection apparatus 100 according to the embodiment may be arranged between the power device 10 and the converter 20. In this case, the converter 20 and the power device 10 may be connected via the P line and N line.

Explaining the abnormal current detection apparatus 100 according to the embodiment of the disclosure, the abnormal current detection apparatus 100 according to the embodiment of the disclosure may be configured to include a semiconductor switch 110. The abnormal current detection apparatus 100 may be connected to a management system 200, and the management system 200 may be configured to control a display unit 300 connected in a wired or wireless manner.

Hereinafter, the configuration of the abnormal current detection apparatus 100 will be described in more detail. First, the abnormal current detection apparatus 100 may be connected to the N line, which is a neutral line, among the lines that constitute the circuit connecting the power device 10 and the power system 30. In this case, among terminals of the semiconductor switch 110, a source terminal may be connected to the N line, and a drain terminal of the semiconductor switch 110 may be grounded. As the neutral line is grounded through the semiconductor switch 50 in this way, the neutral line, i.e., the N line, may become a ground line. Therefore, a return current flowing through the neutral line can be grounded via the semiconductor switch 110. Therefore, when a ground fault occurs in the power device 10, an abnormal current, such as ground fault current, leakage current, or short-circuit current, generated by the ground fault can be grounded via the semiconductor switch 110. That is, when a ground fault occurs, a ground fault current, leakage current, or short-circuit current is added, so the magnitude of a current flowing into the semiconductor switch 110 may increase. Therefore, it is possible to detect whether a ground fault current, leakage current, or short-circuit current occurs based on the magnitude of the current flowing into the semiconductor switch 110.

Meanwhile, the semiconductor switch 100 may include a source terminal and a drain terminal, and a gate terminal that electrically connects the source terminal and the drain terminal. Here, the semiconductor switch 110 is formed to electrically connect the source terminal and the drain terminal when a voltage applied to the gate terminal is higher than or equal to a preset threshold voltage. Therefore, the semiconductor switch 110 may detect whether a ground fault current has occurred by using the voltage applied to the gate terminal, i.e., a gate voltage, and may disconnect the power device 10 in which the ground fault current has occurred from the power system 30.

To this end, the abnormal current detection apparatus 100 according to the embodiment may be configured to include a gate driver 111 that applies the gate voltage to the gate terminal. The gate driver 111 may be configured to include a controller 130 that controls the gate voltage applied to the gate terminal.

In more detail, the controller 130 may detect a magnitude of a return current flowing to the ground via the semiconductor switch 110 and determine whether the detected magnitude is higher than or equal to a preset ground fault detection current. When the detected current magnitude is less than the ground fault detection current, the controller 130 may control the gate driver 111 so that the source terminal and the drain terminal are normally electrically connected to each other. In this case, the controller 130 may control the gate driver 111 to apply the gate voltage higher than or equal to the preset threshold voltage to the gate terminal, such that the source terminal and the drain terminal are electrically connected. Accordingly, the return current may flow to the ground. Then, the power device 10 and the power system 30 may be connected to each other.

On the other hand, when a magnitude of the return current flowing to the ground via the semiconductor switch 110 is higher than or equal to the preset ground fault detection current, the controller 130 may determine that a ground fault has occurred and control the gate driver 111 to disconnect the connection between the source terminal and the drain terminal. In this case, the controller 130 may control the gate driver 111 to apply a gate voltage less than the preset threshold voltage to the gate terminal, such that the source terminal and the drain terminal are electrically disconnected from each other.

Then, the grounding of the neutral line can be open, and the connection between the power device 10 and the power system 30 can be cut off. That is, the power device 10 can be disconnected from the power system 30. When the power device 10 is disconnected from the power system 30, the abnormal current detection apparatus 100 according to the embodiment may notify the management system 200 that a ground fault has occurred between the power device 10 and the power system 30.

In this way, when the connection between the source terminal and the drain terminal is disconnected based on a result of detecting the current flowing through the ground line, the controller 130 of the abnormal current detection apparatus 100 may control the gate driver 111 to apply a voltage higher than or equal to the threshold voltage at a preset time interval. In this case, the source terminal and the drain terminal may be electrically re-conducted, and the current flowing in the neutral line may flow to the ground again via the semiconductor switch 110.

When the source terminal and the drain terminal are connected, the controller 130 may detect the current flowing to the ground line again. According to the detection result, the controller 130 may re-detect whether the power device 10 is in a ground fault state depending on whether the current flowing to the ground line is higher than or equal to a preset ground fault detection current.

Meanwhile, the connection between the source terminal and the drain terminal may be a temporary connection for re-detecting whether the power device 10 is in the ground fault state. That is, the temporary connection is a connection between the source terminal and the drain terminal in a state where the current flowing to the ground via the semiconductor switch 110 is not less than the ground fault detection current, and a gate voltage applied to the gate terminal to connect the source terminal and the drain terminal for the temporary connection may be a different voltage from a voltage applied to the gate terminal in a normal case, i.e., in a state where it has been confirmed that the current flowing to the ground via the semiconductor switch 110 is less than the ground fault detection current.

For example, the controller 130 may control the maximum amount of current which can flow between the source terminal and the drain terminal by controlling the magnitude of the gate voltage. That is, when a gate voltage (higher than or equal to a threshold voltage) is lower, the maximum value of current which can be output through the semiconductor switch 110, i.e., the maximum value of current which can be output through the source terminal and the drain terminal may become smaller. On the other hand, when a gate voltage (higher than or equal to a threshold voltage) is higher, the maximum value of current which can be output through the semiconductor switch 110, i.e., the maximum value of current which can be output through the source terminal and the drain terminal may become greater. By limiting the maximum value of the output current, the magnitude of current flowing into the semiconductor switch 110 may also be limited.

Accordingly, the controller 130 can limit the magnitude of the gate voltage applied to the gate terminal in the case of the temporary connection to be lower than that of the gate voltage applied to the gate terminal so that the power device 10 and the power system 30 are connected in a normal case, i.e., in a normal state in which no ground fault is detected.

As such, the abnormal current detection apparatus 100 according to the embodiment can limit the magnitude of the current which flows into and out of the semiconductor switch 110 by limiting the gate voltage level when the source terminal and the drain terminal are temporary connected, thereby minimizing the magnitude of the current flowing into and out of the semiconductor switch 110 for ground fault detection. This can suppress safety accidents and damage to the abnormal current detection apparatus 100.

In the state where the gate voltage applied to the gate terminal to disconnect the source terminal and the drain terminal due to the ground fault current is controlled, the controller 130 of the abnormal current detection apparatus 100 according to the embodiment can arbitrarily apply a gate voltage higher than or equal to the threshold voltage to the gate terminal to check whether the ground fault state continues. The controller 130 may re-determine whether the power device 10 is in a ground fault state based on the current of the neutral line which is introduced when the gate voltage higher than or equal to the threshold voltage is applied.

When it is determined whether the power device 10 is in the ground fault state, the controller 130 may notify the management system 200 of the determined state of the power device 10. To this end, the abnormal current detection apparatus 100 according to the embodiment of the disclosure may further include a communication unit 140 which is controlled by the controller 130 and performs a wireless or wired communication connection with the management system 200.

The management system 200 may be a system for managing a result of determining whether a ground fault has occurred, which is received from the abnormal current detection apparatus 100. For example, the management system 200 may be a power management system (PMS). The management system 200 may detect that a ground fault has occurred between the power device 10 and the power system 30 based on ground fault detection information received from the abnormal current detection apparatus 100 according to the embodiment of the disclosure.

The controller 130 may receive a result of determining whether the ground fault has occurred from the abnormal current detection apparatus 100 according to the embodiment, and detect whether a ground fault has occurred between the power device 10 and the power system 30 (whether a ground fault exists). The controller 130 may control the display unit 300 to output the received result of determining whether the ground fault has occurred, such that an operator can easily identify whether the ground fault exists.

Here, the display unit 300 may include at least one of a display and an audio output module for displaying the presence or absence of the ground fault between the power device 10 and the power system 30 as visual or auditory information, and may be configured to perform communication with the management system 200. The display unit 300 may be arranged in a separate device which is distinct from the management system 200. For example, the display unit 300 may be a mobile terminal, such as a smartphone, PDA, or tablet PC carried by the operator. Therefore, through the display unit 300, the operator can easily check whether a ground fault exists between the power device 10, which he or she is currently trying to work on, and the power system 30.

Meanwhile, when a current flowing into the semiconductor switch 110 from the ground line is less than a preset current value while the source terminal and the drain terminal are temporarily connected, the controller 130 may determine that the ground fault of the power device 10 has been repaired and thus the power device 10 and the power system 30 can be normally connected. Then, the controller 130 may control the gate driver 111 to apply an unlimited gate voltage. Accordingly, the maximum output current between the source terminal and the drain terminal can be restored into a normal range. Therefore, the power device 10 can be normally connected to the power system 30 as the source terminal and the drain terminal are normally electrically connected and the neutral line is connected to the ground.

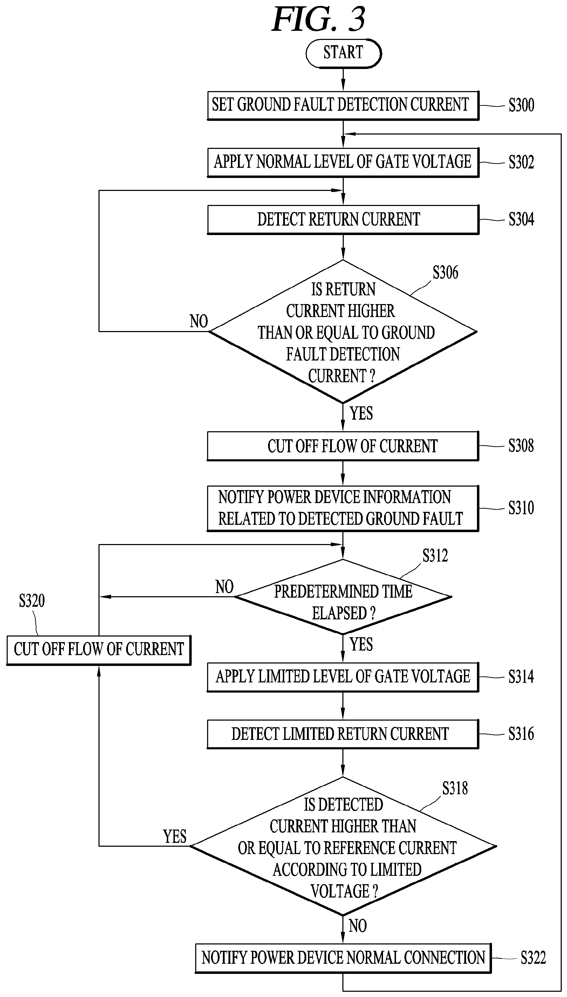

FIG. 3 is a flowchart of an operation process of an abnormal current detection apparatus according to an embodiment of the disclosure to detect a ground fault and determine whether a ground fault exists.

Referring to FIG. 3, when power is turned on, the controller 130 of the abnormal current detection apparatus 100 according to the embodiment of the disclosure may first set magnitude of a ground fault detection current by the management system 200 or according to prestored data (S300). The controller 130 may control the gate driver 111 to apply a gate voltage of a normal level (S302). Here, the gate voltage of the normal level refers to a gate voltage applied when the normally driven power device 10 is connected to the power system 30, and may be a voltage having magnitude higher than or equal to a threshold voltage.

When the gate voltage of the normal level is applied in step S302, the controller 130 may detect magnitude of a current flowing into the semiconductor switch 110 connected between the neutral line and the ground, i.e., magnitude of a current applied from the neutral line to the ground, through the semiconductor switch 110 (S304). The controller 130 may determine whether the detected magnitude of the return current is higher than or equal to the ground fault detection current set in step S300 (S306).

The controller 130 of the abnormal current detection apparatus 100 according to the embodiment of the disclosure determines whether a ground fault has occurred by comparing the detected return current with the prestored value, i.e., the ground fault detection current. Therefore, regardless of a fuse blowing current, the controller 130 can determine whether a ground fault has occurred by comparing the current value according to the received or prestored ground fault detection current information with the detected return current value.

Therefore, unlike the related art GFDI which can detect a ground fault only based on the fuse blowing current, the abnormal current detection apparatus 100 according to the embodiment of the disclosure can detect whether a ground fault has occurred based on a current lower than the fuse blowing current, or can freely detect a ground fault even in a circuit where a high-capacity return current, exceeding the fuse blowing current, flows while the power device 10 and the power system 30 are normally connected. That is, there is an advantage in that the detection of the occurrence or non-occurrence of the ground fault can be made easier by dynamically setting the ground fault detection current for determining whether the ground fault has occurred.

Meanwhile, when the detected return current is less than the preset ground fault detection current as a result of the determination in step S306, the controller 130 may determine that a ground fault has not occurred in the power device 10. Accordingly, the controller 130 can proceed back to step S304 to re-detect the return current and perform the process again up to step S306 of comparing the detected return current with the preset ground fault detection current.

However, in step S306, when the detected return current is higher than or equal to the preset ground fault detection current, the controller 130 may determine that a ground fault has occurred in the power device 10. The controller 130 may then control the gate driver 111 to apply a gate voltage lower than a preset threshold voltage to the gate terminal of the semiconductor switch 110. Accordingly, the electrical connection between the source terminal and the drain terminal of the semiconductor switch 110 may be cut off, which may lead to disconnection between the neutral line and the ground, thereby cutting off the electrical connection between the power device 10 and the power system 30(S308).

When the electrical connection between the power device 10 and the power system 30 is cut off in step S308, the controller 130 may control the communication unit 140 to transmit ground fault detection information to the management system 200 to notify the occurrence of the ground fault (S310). In this case, the ground fault detection information may include information regarding the power device associated with the currently detected ground fault, i.e., information regarding the power device 10 connected to the power system 30 via the neutral line to which the abnormal current detection apparatus 100 according to the embodiment of the disclosure is connected, and may be transmitted to the management system 200.

Then, the management system 200 may identify the power device 10 associated with the detected ground fault and control the display unit 300 to display the identified power device 10 to be distinguished from other power devices.

Meanwhile, in step S308, when the electrical connection between the source terminal and the drain terminal of the semiconductor switch 110 is cut off, the controller 130 may check whether a predetermined time has elapsed (S312). When the predetermined time has elapsed, the controller 130 may control the gate driver 111 to apply a gate voltage higher than or equal to the threshold voltage to the gate terminal of the semiconductor switch 110, such that the source terminal and the drain terminal are temporarily connected (S314).

In this case, for the temporary connection between the source terminal and the drain terminal, the controller 130 may control the gate driver 111 to apply a gate voltage of a limited level to the gate terminal.

Here, the gate voltage of the limited level (magnitude) may be a gate voltage of a lower level than the gate voltage of the normal level (magnitude). That is, both the gate voltage of the limited level and the gate voltage of the normal level may be higher than or equal to the threshold voltage, but the gate voltage of the limited level may be lower than the gate voltage of the normal level. Therefore, as the gate voltage is limited, the magnitude of the current output from the neutral line to the ground can also be limited.

Meanwhile, as the gate voltage of the limited level is applied to the gate terminal in step S314, the source terminal and the drain terminal may be temporarily connected. Therefore, the neutral line and the ground can be temporarily connected, such that the current of the neutral line can flow to the ground. The controller 130 may detect magnitude of a current flowing through the source terminal and the drain terminal according to the gate voltage of the limited level, that is, magnitude of a return current according to the limited gate voltage (hereinafter, referred to as a limited return current) (S316).

As a result of the check in step S316, the controller 130 may determine whether a ground fault current is still detected from the power device 10 according to the limited return current. In more detail, in step S316, the controller 130 may determine whether a ground fault current is detected from the power device 10, based on a result of comparing the magnitude of the limited return current with a preset reference current (S318).

Here, the reference current may be a current whose magnitude is different from that of the ground fault detection current. For example, in the case of the limited return current, the flow of the current may be limited by the limited gate voltage. Therefore, the reference current may be a current which is smaller in magnitude than the ground fault detection current.

As a result of comparing the magnitude of the limited return current with the preset reference current in step S318, when the limited return current is higher than or equal to the reference current, the controller 130 may determine that the ground fault current is still detected from the power device 10.

The controller 130 may then control the gate terminal to apply a gate voltage less than the threshold voltage, thereby cutting off the electrical connection between the source terminal and the drain terminal (S320). Then, the controller 130 may go back to step S312, and determine whether a predetermined time has elapsed, and when the predetermined time has elapsed, may repeatedly perform the process from step S314 to step S318 to detect whether the limited return current is higher than or equal to the reference current.

On the other hand, when the limited return current is less than the reference current according to a result of the determination in step S318, the controller 130 may determine that a ground fault current is no longer detected from the power device 10 by virtue of repair and the like. Then, the controller 130 may control the communication unit 140 to transmit to the management system 200 that the power device 10 is normally connected (S322).

By proceeding to step S302, the controller 130 may control the gate driver 111 to apply the gate voltage of the normal level to the gate terminal. Then, the source terminal and the drain terminal can be connected in a normal state where the magnitude of the output current is restored, rather than a temporary connection where the magnitude of the output current is limited. The controller 130 may perform the process after step S304 again.

Meanwhile, the management system 200 may initialize ground fault occurrence information regarding a power device associated with a ground fault based on received power device normal connection notification. Therefore, the operator can recognize through the display unit 300 that the power device 10 in which the ground fault current was detected has been repaired.

Meanwhile, the above description has been given of the configuration that the abnormal current detection apparatus 100 according to the embodiment of the disclosure applies a gate voltage having a limited voltage level to the gate terminal when temporarily connecting the source terminal and the drain terminal to check whether a ground fault current is still flowing from the power device 10. However, it is of course possible to apply a gate voltage of a normal level.

In this case, the reference voltage described in step S318 may be a voltage having the same level as the ground fault detection current described in step S300. In this case, the source terminal and drain terminal, which are temporarily connected to check whether or not the ground current is still flowing from the power device 10, are electrically connected according to the gate voltage of the normal level. Therefore, when the ground current is not detected as the result of the determination in step S318, the return current can be detected while maintaining the state in which the gate voltage is applied. That is, the step S302 of restoring the gate voltage to a normal state may be omitted, and the process may proceed directly to the step after step S304.

The previous description has been given of the configuration that the abnormal current detection apparatus 100 according to the embodiment of the disclosure determines whether a ground fault current is detected from the power device 10 based on the preset reference voltage. However, the reference voltage may also be set from the management system 200 under the control of the management system 200. In this case, when the ground fault detection information is received, the management system 200 may identify the power device 10 associated with the detected ground fault, and transmit a reference current corresponding to the identified power device 10 to the abnormal current detection apparatus 100, in response to the ground fault detection information.

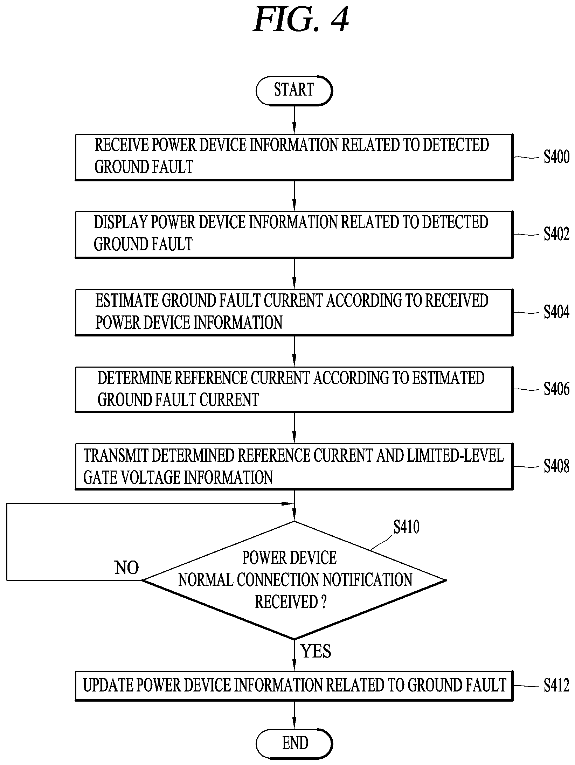

FIG. 4 is a flowchart of an operation process of the management system 200 according to ground fault detection when a reference current is set according to the control of the management system.

Referring to FIG. 4, when the abnormal current detection apparatus 100 detects a ground fault current, the management system 200 may receive information, which is related to a power device associated with the ground fault current detected from the abnormal current detection apparatus 100, i.e., a power device 10 to which the abnormal current detection apparatus 100 is connected, as ground fault detection information (S400).

Then, the management system 200 may update the status of the received power device to a ground fault occurrence status and simultaneously control the display unit 300 so that the received power device is displayed differently from other power devices from which ground fault detection information has not been received (S402).

As described above, the display unit 300 may be a device that can be checked by the operator, for example, a mobile terminal of the operator. Therefore, the operator can perform work by distinguishing the power device 10 in which a ground fault has been detected from power devices in which a ground fault has not been detected. Accordingly, safety accidents that may occur due to the ground fault current can be suppressed.

Meanwhile, the management system 200 may estimate an approximate magnitude of a ground fault current which may occur, based on the information on the power device 10 according to the received ground fault detection information (S404). For example, the magnitude of the ground fault current may be estimated based on at least one of transmission power, line voltage, power factor, transformer ratio, wiring method, and neutral point resistance of the power device 10 where the ground fault has occurred. In this case, the approximate magnitude of the ground fault current may be estimated in a certain range.

When the approximate magnitude of the ground fault current is estimated in step S404, the management system 200 may determine a reference current according to the estimated magnitude of the ground fault current (S408). In step S408, the management system may determine the reference current according to the estimated ground fault current magnitude and a limited return current magnitude according to the gate voltage of the limited level.

For example, the management system 200 may determine a level of a gate voltage to be limited based on the estimated magnitude of the ground fault current. That is, when the estimated magnitude of the ground fault current is in a certain range, the level of the gate voltage may be limited to a reference limit level. However, when the ground fault current exceeds the certain range, the management system 200 may limit the gate voltage level to a level lower than the reference limit level, which can ensure that the magnitude of the current flowing into the semiconductor switch 110 through the temporary connection is further reduced.

When the gate voltage level to be limited is determined in this way, the management system 200 may determine magnitude of a reference current to re-detect whether a ground fault current has occurred according to the limited gate voltage level. In this case, when a gate voltage has a lower level, a current magnitude which can flow through the semiconductor switch 110 may be reduced. Therefore, when the gate voltage has the lower level, the reference current for re-detecting whether a ground fault current has occurred may also be reduced.

When the reference current and the level of the gate voltage to be limited are determined in step S406, the management system 200 may transmit information on the determined reference current and the level of the gate voltage to be limited to the abnormal current detection apparatus 100, in response to the transmission of the ground fault detection information (S408). In response to the abnormal current detection apparatus 100 transmitted to the management system 200, the abnormal current detection apparatus 100 may receive the information on the determined reference current and the level of the gate voltage to be limited, and may re-detect whether a ground fault current has occurred in the process after step S312 of FIG. 3 based on the received information.

Meanwhile, when information on the reference current and the level of the gate voltage to be limited is transmitted to the abnormal current detection apparatus 100, the controller 130 may check whether power device normal connection notification information has been received from the abnormal current detection apparatus 100 (S410).

In this case, when, in the process after step S312 of FIG. 3, a ground fault current is not detected according to a result of re-detecting whether the ground fault current has occurred in the power device 10, the abnormal current detection apparatus 100 may transmit the power device normal connection notification to the management system 200 in step S322 of FIG. 3. Therefore, as a result of the check in step S410, it can be checked that the power device normal connection notification has been received from the abnormal current detection apparatus 100.

Then, the management system 200 may update the status information on the power device 10 in which the ground fault has occurred based on the ground fault detection information in step S300 (S412). Accordingly, the fact that no ground current is detected from the power device 10 can be displayed on the display unit 300 carried by the operator. Therefore, the operator can recognize that the ground fault and the like of the power device 10 has been repaired.

The foregoing description has been given of the configuration that the reference current is controlled by the management system 200, but it is of course possible that not only the reference current but also the ground fault detection current may be set by the management system 200.

For example, when a communication connection is established with the abnormal current detection apparatus 100, the management system 200 may receive information on the power device 10 connected to the abnormal current detection apparatus 100, and transmit information on a ground fault detection current corresponding to the received information on the power device 10 to the abnormal current detection apparatus 100. Then, the abnormal current detection apparatus 100 may determine whether a ground fault current has occurred from the connected power device 10 based on the ground fault detection current received from the management system 200.

As such, the ground fault detection current as well as the reference current can be controlled by the management system 200. Therefore, the management system 200 can set at least one of the ground fault detection current and the reference current differently for each power device 10 connected to each abnormal current detection apparatus 100. For example, the management system 200 may set a ground fault detection current and a reference current to more sensitively determine whether a ground fault has occurred in a power device, in which a ground fault has occurred more than a preset number of times, based on a ground fault occurrence history of the connected power device 10. In this case, the management system 200 may set the ground fault current and reference current of the connected power device 10 to be lower than those of other power devices (e.g., other power devices of the same type), thereby more sensitively detecting whether a ground fault has occurred.

Alternatively, the management system 200 may set ground fault detection current and reference current for a power device, which is arranged in a space where it is easily affected by noise and the like, so that the ground fault detection operation is more insensitively performed in the corresponding power device. In this case, the management system 200 may set the ground fault detection current and reference current of the corresponding power device to be higher than those of other power devices (e.g., other power devices of the same type), thereby more insensitively detecting whether a ground fault has occurred.

Meanwhile, the foregoing description has been given of an example of only determining whether the ground fault current has occurred based on whether the magnitude of the return current is higher than or equal to the preset ground fault detection current. However, unlike this, even though the detected return current is less than the ground fault detection current, when the measured current meets an abnormal current condition based on an analysis result of the measured current, the controller 130 may of course control the gate driver 111 to disconnect the power device 10 from the power system 30. In another example, the controller 130 may control the gate driver 111 so that the power device 10 is not disconnected from the power system 30 as the measured return current does not meet the abnormal current condition when the detected return current is an overcurrent, which temporarily occurs due to noise. That is, the controller 130 may determine whether an abnormal current has occurred depending on whether the current characteristic meets a preset abnormal current condition as a result of analyzing the characteristic of the measured return current, thereby suppressing malfunctions caused by disconnecting the power device 10 from the power system 30 based on a uniform determination of whether or not the measured return current is an overcurrent.

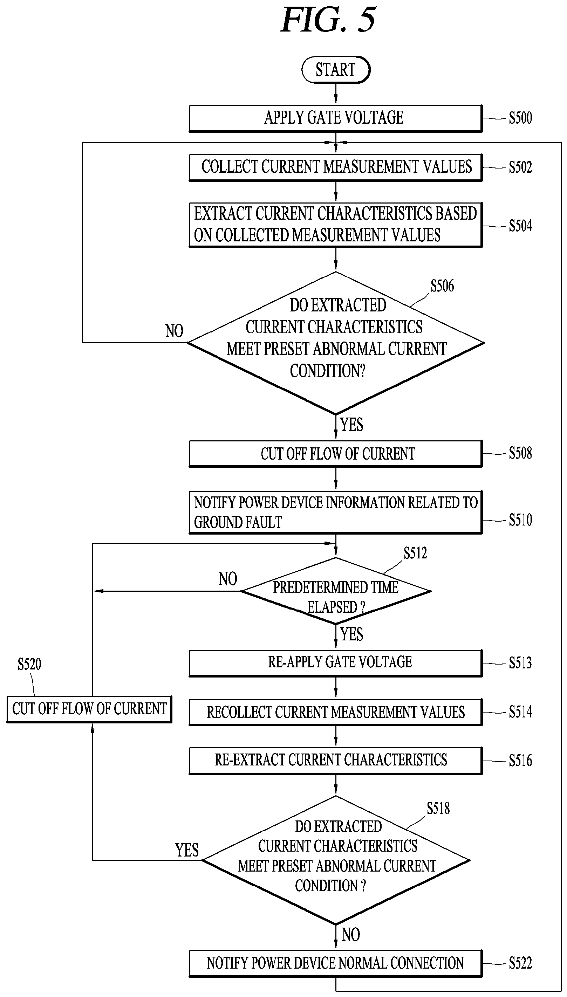

FIG. 5 is a flowchart of an operation process of the abnormal current detection apparatus 100 according to the embodiment of the disclosure to detect a ground fault based on an abnormal current detection result.

Referring to FIG. 5, the abnormal current detection apparatus 100 according to the embodiment of the disclosure may control the gate driver 111 to apply a gate voltage to the gate terminal when its operation is started (S500). In this case, the gate voltage may be a normal level of gate voltage. Currents of a neutral line flowing into the semiconductor switch 110 may be measured for a predetermined period of time, thereby collecting measurement values (S502). Current characteristics may be extracted from the collected measurement values (S504).

Here, the current characteristics may be calculated based on statistics on current magnitude, such as minimum current magnitude or maximum current magnitude and average current magnitude. Alternatively, the current characteristics may include not only the magnitude but also an amount of change in current magnitude over time (e.g., a slope of the current change over time).

When the current characteristics are extracted in step S504, the controller 130 may determine whether the extracted current characteristics satisfy a preset abnormal current condition (S506). Here, the preset abnormal current condition may be a condition set according to a prestored abnormal current profile. Here, the abnormal current profile may be prestored in the abnormal current detection apparatus 100 according to the embodiment of the disclosure, or may be transmitted to each abnormal current detection apparatus from the management system 200.

The controller 130 may compare the current characteristics extracted from the collected measurement values with current characteristics according to the abnormal current profile. As a result of the comparison, when the extracted current characteristics match the characteristics according to the abnormal current profile by a preset level or more, the controller 130 may determine that the extracted current characteristics indicate an abnormal current that satisfies the preset condition.

For example, the abnormal current profile may include at least one of the following information: the change in current magnitude over time (e.g., a slope of change in current magnitude over time), an average current magnitude, a difference between maximum current value and minimum current value, and the like.

In this case, the controller 130 may determine that an abnormal current has occurred when the current characteristics detected according to the current measurement values, for example, the change in current magnitude over time, satisfies the condition according to the change in current magnitude over time according to the preset abnormal current profile. Alternatively, the controller 130 may determine that an abnormal current has occurred when the average current magnitude or the difference between the maximum current value and the minimum current value is greater than or equal to an average current magnitude or the difference between the maximum and minimum values according to the preset abnormal current profile.

Then, the controller 130 may control the gate driver 111 to apply a gate voltage less than a threshold voltage, so that the electrical connection between the source terminal and the drain terminal is cut off (S508). The controller 130 may provide ground fault detection information including information on the power device 10 associated with the ground fault to the management system 200 (S510).

On the other hand, when the current characteristics extracted according to the current measurement values do not match the abnormal current profile, the controller 130 may determine that no abnormal current has occurred. The controller 130 may then proceed back to step S502 to receive the current measurement values and perform step S504 to extract the current characteristics from the received current measurement values, and perform step S506 to determine whether the extracted current characteristics satisfy the abnormal current condition.

Meanwhile, when the ground fault detection information is transmitted to the management system 200 in step S510, the controller 130 may check whether a predetermined time has elapsed (S512). When the predetermined time has elapsed, the controller 130 may control the gate driver 111 to apply a gate voltage higher than or equal to the threshold voltage to the gate terminal of the semiconductor switch 110, such that the source terminal and the drain terminal are temporarily connected (S513). In this case, for the temporary connection between the source terminal and the drain terminal, the controller 130 may control the gate driver 111 to temporarily apply a gate voltage to the gate terminal.

As the gate voltage is temporarily applied to the gate terminal in step S513, the source terminal and the drain terminal may be temporarily connected. Therefore, the neutral line and the ground can be connected, such that the current in the neutral line can flow to the ground. The controller 130 may re-collect measurement values of the currents flowing through the temporarily connected source terminal and drain terminal (S514).

The controller 130 may re-extract current characteristics based on the current measurement values re-collected in step S514 (S516). The controller 1300 may re-determine whether the re-extracted current characteristics satisfy the preset abnormal current condition (S518).

As a result of the determination in step S518, when the re-extracted current characteristics satisfy the preset abnormal current condition, the controller 130 may determine that the abnormal current is still detected from the power device 10. Then, the controller 130 may control the gate driver 111 to apply a gate voltage lower than the threshold voltage (S520). Then, the controller 130 may go back to step S512, and determine whether a predetermined time has elapsed, and when the predetermined time has elapsed, may repeatedly perform the process from step S513 to step S518 to re-determine whether the return current meets the preset abnormal current condition.

On the other hand, when the limited return current does not meet the abnormal current condition according to a result of the re-determination in step S518, the controller 130 may determine that a ground fault current is no longer detected from the power device 10 by virtue of repair and the like. Then, the controller 130 may control the communication unit 140 to transmit to the management system 200 that the power device 10 is normally connected (S522). The controller 130 may proceed to step S502, to collect the current measurement values from the return current and perform the subsequent steps again.

Meanwhile, the foregoing description has been given of an example in which one power device 10 is connected to the power system 30, and the abnormal current detection apparatus 100 according to the embodiment of the disclosure is arranged between the one power device 10 and the power system 30. Here, the abnormal current detection apparatus 100 may be a semiconductor circuit breaker (e.g., solid state circuit breaker (SSCB)) including the semiconductor switch 110 as described above.

However, it goes without saying that the disclosure is not limited to this configuration. That is, a plurality of power devices may be connected to the power system 30, and in this case, the abnormal current detection apparatus 100 according to the embodiment of the disclosure may be arranged between each power device and the power system.

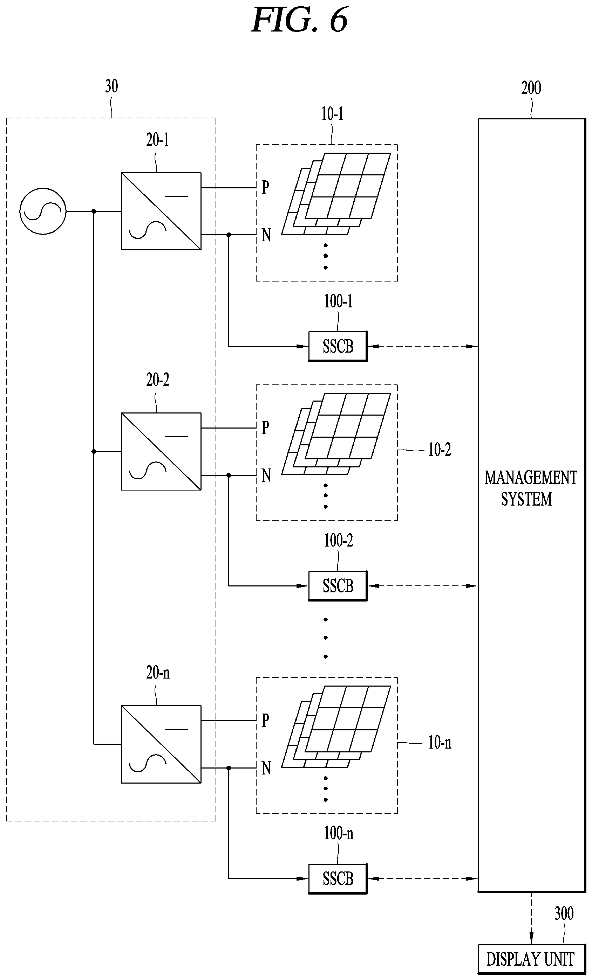

FIG. 6 is a view of an example of abnormal current detection apparatuses according to an embodiment, which are arranged between a plurality of power devices and the power system when the plurality of power devices are connected to the power system.

Referring to FIG. 6, a power system 30 including a plurality of converters 20-1, 20-2, ..., 20-n may be connected to a plurality of power devices 10-1, 10-2, ..., 10-n. In this case, abnormal current detection apparatuses 100-1, 100-2, ..., 100-n according to the embodiment of the disclosure may be arranged between the respective power devices and the power system 30.

Here, each of the abnormal current detection apparatuses according to the embodiment of the disclosure may be connected between a neutral line, among lines which connect the corresponding abnormal current detection apparatus and the power system 30, and the ground. In more detail, a source terminal of a semiconductor switch 110 arranged in each abnormal current detection apparatus may be connected to the neutral line, while a drain terminal of the semiconductor switch 110 may be connected to the ground.

Therefore, the neutral line can be connected to the ground via the semiconductor switch 110 of each abnormal current detection apparatus 100. Each of the abnormal current detection apparatuses 100-1, 100-2, ..., and 100-n may be connected to the management system 200. The management system 200 may be connected to a display unit 300.

In this case, the controller 130 of each abnormal current detection apparatus may determine whether a ground fault current has occurred based on a current flowing into the semiconductor switch 110. When a ground fault current is detected, the controller 130 may provide ground fault detection information to the management system 200. Then, the management system 200 may identify a power device, in which a ground fault has occurred, among the connected power devices 10-1, 10-2, ..., 10-n, based on information on the abnormal current detection apparatus 100 from which the ground fault detection current has been received.

Meanwhile, the controller 130 of the abnormal current detection apparatus which has detected the ground fault current may primarily control the gate driver to apply a gate voltage lower than a preset threshold voltage of the semiconductor switch 110 to the gate terminal of the semiconductor switch 110.

Accordingly, the electrical connection between the source terminal and the drain terminal of the semiconductor switch 110 can be cut off, and the connection between the ground and the neutral line connecting the power device where the ground current has been detected and the power system 30 can be cut off. Therefore, the power device in which the ground fault current has been detected can be disconnected from the power system 30.

In this way, when the power device is cut off from the power system 30, the controller 130 may check whether a predetermined time has elapsed. After the predetermined time has elapsed, the controller 130 may control the gate driver to apply a gate voltage higher than or equal to the threshold voltage of the semiconductor switch 110 to the gate terminal of the semiconductor switch 110.

Then, the source terminal and drain terminal of the semiconductor switch 110 may be temporarily connected (temporary connection), and the connection between the ground and the neutral line connecting the power device and the power system 30 may be temporarily made again.

Therefore, the current of the neutral line may be introduced into the semiconductor switch 110 of the abnormal current detection apparatus again. Then, the controller 130 may re-detect whether a ground fault current is included based on an introduced current, and maintain or cut off again the electrical connection between the source terminal and the drain terminal according to a result of the detection. In this case, when the source terminal and the drain terminal are electrically disconnected, the aforementioned process may be repeated until the power device in which the ground fault current has been detected is repaired and the ground fault current is no longer detected.

Here, in the case of the temporary connection, the controller 130 may control the gate voltage to limit the maximum amount of current that can flow through the source terminal and the drain terminal.

In case where the maximum amount of current which can flow during the temporary connection is limited, the controller 130 may also restore the gate voltage level to a normal level when the ground fault current is no longer detected by virtue of the repair and the like.

When the abnormal current is not detected according to a result of the determination, the controller 130 of each abnormal current detection apparatus may transmit information indicating that no ground current is detected (e.g., a power device normal connection notification) to the management system 200.

Then, the management system 200 may distinctively display information on the power device, in which the ground fault current is not detected, among power devices in which the ground fault current has been detected, on the display unit 300.

Therefore, even when a plurality of power devices are connected, a power device in which the ground fault state has been repaired and a power device in which the ground fault state has not been repaired yet can be easily identified and distinguished.

Meanwhile, the foregoing description of the disclosure has been given of the detailed embodiment, but various modifications may be made without departing from the scope of the disclosure. In particular, in the embodiment of the disclosure, the configuration in which the display unit 300 is controlled by the management system 200 has been described, but it is of course possible that the display unit 300 may be controlled directly from the abnormal current detection apparatus 100 according to the embodiment of the disclosure.

For example, an operator may request information on whether a target power device is operating normally from the abnormal current detection apparatus according to the embodiment of the disclosure, which is connected to the target power device, and the abnormal current detection apparatus may provide information on whether the target power device is operating normally in response to the request. In this case, information on whether the power device is operating normally may be provided to the operator without going through the management system.

Meanwhile, the foregoing description has been given of the configuration of controlling the gate driver to apply a gate voltage lower than the threshold voltage of the semiconductor switch to the gate terminal to cut off the electrical connection between the source terminal and the drain terminal.

However, it is obvious that the configuration of controlling the gate driver to apply the gate voltage lower than the threshold voltage to the gate terminal may also include a configuration of controlling the gate driver such that the gate voltage is not applied to the gate terminal.

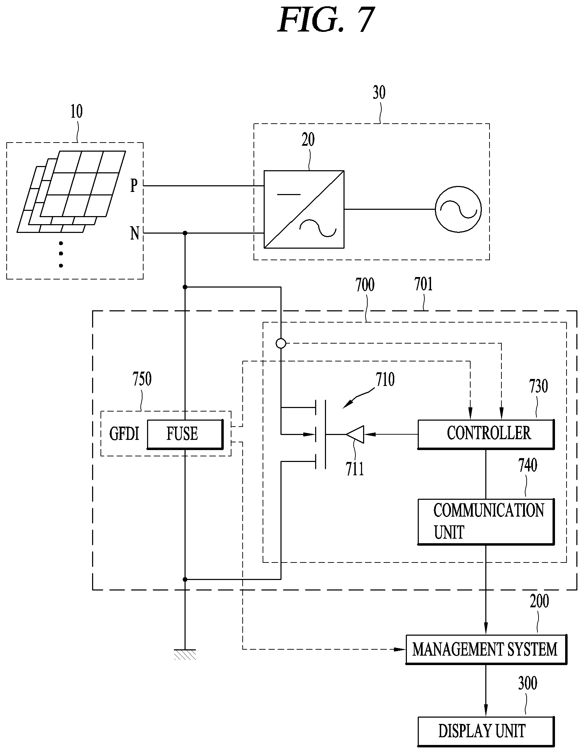

FIG. 7 is a block diagram of a structure of an abnormal current detection apparatus having a semiconductor circuit breaker according to another embodiment of the disclosure.

First, explaining the gist of the disclosure according to another embodiment of the disclosure, to solve the problem of the related art GFDI, that is, the problem that an operator cannot recognize whether or not a ground fault has occurred in a circuit connected to the GFDI he or she is working on because the circuit remains open regardless of whether a ground fault has been repaired when the ground fault is detected, an abnormal current detection apparatus according to this embodiment may further include a detector configured to check whether a ground fault has been repaired when the ground fault is detected by the GFDI.

Meanwhile, the abnormal current detection apparatus according to this embodiment may use a semiconductor circuit breaker (e.g., a solid state circuit breaker (SSCB)) using a semiconductor switch as the detector. By detecting whether an abnormal current has occurred according to a detection threshold value of the semiconductor circuit breaker, the abnormal current can be easily detected regardless of the magnitude of the abnormal current, and when the abnormal current is detected, a power device can be quickly disconnected from a power system.

Hereinafter, the another embodiment of the disclosure will be described in detail with reference to the accompanying drawings.

Explaining the abnormal current detection apparatus 701 according to this embodiment, the abnormal current detection apparatus 701 according to this embodiment may include a current detection unit 750 configured to primarily detect abnormal currents generated from various abnormal phenomena, such as overcurrent, short-circuit, ground fault, and voltage abnormality, based on preset detection criteria.

As the current detection unit, there may be a ground fault detection indicator (GFDI). The GFDI may include a fuse, and when a current exceeding a certain level of blowing current flows at which the fuse blows, the fuse may blow and the abnormal current may be detected.

In the following description, for convenience of explanation, the current detection unit 750 is assumed to be the GFDI. However, it goes without saying that the disclosure is not limited to this. That is, it goes without saying that other types of current detection units that detect various types of abnormal currents, such as ground fault current or short-circuit current, may be employed instead of the GFDI 750 to be described below.

The abnormal current detection apparatus according to this embodiment will be described under assumption that the GFDI is provided as the current detection unit. An abnormal current detection apparatus 701 according to an embodiment of the disclosure may include a GFDI 750 configured to detect presence or absence of an abnormal current according to blowing of a fuse, and a semiconductor circuit breaker (i.e., SSCB) 700 connected to the GFDI 750. The GFDI 750 and the semiconductor circuit breaker 700 may each be connected to a management system 200, and the management system 200 may be configured to control a display unit 300 connected in a wired or wireless manner.

Hereinafter, the configuration of the abnormal current detection apparatus 701 will be described in more detail. First, the abnormal current detection apparatus 701 may be connected to an N line, which is a neutral line, among lines that constitute a circuit connecting the power device 10 and the power system 30. In this case, a first pole of fuse poles of the GFDI 750 may be connected to the N line and a second pole may be grounded. As the neutral line is grounded through the connected GFDI 750, the neutral line, i.e., the N line, may become a ground line.

Therefore, a return current flowing through the neutral line can be grounded via the GFDI 750. Therefore, in case where a ground fault occurs in the power device 10, when an abnormal current, such as a leakage current or short-circuit current occurs due to the ground fault, the abnormal current can be grounded via the fuse of the GFDI 750. In this case, the fuse may blow when the abnormal current exceeds a fuse blowing current of the GFDI 750. When the fuse blows due to the abnormal current, the GFDI 750 may notify the management system 200 that the abnormal current has occurred between the power device 10 and the power system 30.

Meanwhile, the abnormal current detection apparatus 701 according to this embodiment may include a semiconductor circuit breaker 700 connected to the GFDI 750. The semiconductor circuit breaker 700 may receive ground fault detection information detected by the GFDI 750 through the connected GFDI 750, and may be activated according to the received ground fault detection information.

The semiconductor circuit breaker 700 may include a semiconductor switch 710 formed so that a current can flow between a source terminal and a drain terminal based on a voltage applied to a gate driver 711. The semiconductor circuit breaker 700 may include a gate driver 711 configured to apply a voltage to a gate terminal of the semiconductor switch 710. The semiconductor circuit breaker 700 may include a controller 730 configured to control the gate driver 711.

The controller 730 may control the gate driver 711 to control a voltage (hereinafter, referred to as a gate voltage) applied to the gate terminal. By controlling the gate voltage, the source terminal and drain terminal of the semiconductor switch 710 may be electrically connected or disconnected. In more detail, the controller 730 may control the gate driver 711 to apply a gate voltage higher than or equal to a preset threshold voltage to the gate terminal of the semiconductor switch 710. Then, the source terminal and drain terminal may be electrically connected so that a current can flow. As such, when the source terminal and the drain terminal are electrically connected, the controller 730 may control the maximum amount of current which can flow between the source terminal and the drain terminal by controlling the magnitude of the gate voltage.

On the other hand, the controller 730 may control the gate driver 711 to apply a gate voltage lower than a preset threshold voltage to the gate terminal of the semiconductor switch 710. Then, the source terminal and the drain terminal may be electrically disconnected.

Here, the configuration of controlling the gate driver to apply the gate voltage lower than the threshold voltage of the semiconductor switch to the gate terminal may also include a configuration of controlling the gate driver such that the gate voltage is not applied to the gate terminal.

Meanwhile, when the source terminal and the drain terminal are electrically connected, the neutral line may be connected to the ground via the semiconductor switch 710. Accordingly, a bypass path can be formed in which the neutral line and the ground are connected via the semiconductor switch 710.

A detailed description thereof will be given. The GFDI 750 may be connected to a ground line of a circuit connecting the power device 10 and the power system 30, and the semiconductor circuit breaker 700 may be connected to the ground line. In this case, as shown in FIG. 7, the source terminal and drain terminal of the semiconductor switch 710 may each be connected to the ground line.

More preferably, the source terminal may be connected on a middle of a first pole of the GFDI 750 connected to the neutral line, and the drain terminal may be connected on a middle of a second pole of the GFDI 750 connected to the ground.

When the connection is made, a bypass path may be formed in which the neutral line and the ground are connected by bypassing the GFDI 750 that connects the neutral line and the ground through the semiconductor switch 710. Therefore, even if the neutral line and the ground are open due to the blowing of the fuse arranged in the GFDI 750, grounding can be achieved through the bypass path, so that an electrical connection can be made between the power device 10 and the power system 30.

Meanwhile, as the semiconductor circuit breaker 700 is arranged to form the bypass path that bypasses the GFDI 750, the semiconductor circuit breaker 700 may detect whether an abnormal current is flowing in the ground line, to which the GFDI 750 is connected, after a ground fault is detected through the GFDI 750.

More specifically, for example, when the fuse of the GFDI 750 blows and the ground line is open due to an occurrence of an abnormal current, the semiconductor circuit breaker 700 may be activated. Due to the blowing of the fuse, a current of the neutral line may flow to the semiconductor circuit breaker 700 through the bypass path. The controller 730 may detect the current flowing in the neutral line by detecting the current flowing to the semiconductor circuit breaker 700. On the basis of the detected current and a preset detection value, the controller 130 may determine whether the current flowing in the neutral line contains an abnormal current.

For example, the controller 730 of the semiconductor circuit breaker 700 may determine that the current flowing in the neutral line includes an abnormal current when the current detected from the neutral line is equal to or greater than a preset current value (a ground fault detection current value). Then, the controller 730 of the semiconductor circuit breaker 700 may control the gate driver 711 to apply a gate voltage less than a threshold voltage, so as to release the connection between the source terminal and the drain terminal. Therefore, the bypass path can be cut off.

That is, when the cause of the abnormal current, such as a ground fault, between the power device 10 and the power system 30 remains unresolved, the power device 10 may be disconnected from the power system 30.

In this way, when the connection between the source terminal and the drain terminal is cut off based on a result of detecting the current flowing to the ground line, the controller 730 of the semiconductor circuit breaker 700 may control the gate driver 711 to apply a voltage higher than or equal to the threshold voltage at a preset time interval.

Then, a bypass path connecting the neutral line and the ground may be formed again, and the current of the neutral line can flow into the semiconductor circuit breaker 700 through the bypass path. In this case, the controller 730 may detect the current flowing in the neutral line again, and on the basis of the detection result, control the gate driver 711 to apply the gate voltage lower than the threshold voltage, thereby disconnecting the connection between the source terminal and the drain terminal again.

Meanwhile, when the current flowing in the ground line is detected to be a normal current according to a result of detecting the current flowing in the ground line, the controller 730 of the semiconductor circuit breaker 700 may control the gate driver 711 such that a state in which the gate voltage higher than or equal to the threshold voltage is applied is maintained. Then, the source terminal and the drain terminal may be connected, and the neutral line and the ground may be connected through the bypass path, bypassing the GFDI 750 where the fuse has blown. Therefore, the circuit connecting the power device 10 and the power system 30 can be closed.

Consequently, even if the fuse of the GFDI 750 has blown, the power device 10 and the power system 30 can be connected. That is, when a ground fault is rectified, the abnormal current detection apparatus 701 according to this embodiment may electrically connect the power device 10 and the power system 30 even without replacing the GFDI 750 whose fuse has blown due to the occurrence of the abnormal current.

When the power device 10 and the power system 30 are connected through the bypass path, the connection may be a temporary connection between the power device 10 and the power system 30 until the blown fuse of the GFDI 750 is replaced. That is, when the GFDI 750 is replaced and a current flows again through the poles of the fuse, the semiconductor circuit breaker 700 may be deactivated again.

Accordingly, the neutral line and the ground may be reconnected through the GFDI 750. The connection between the power device 10 and the power system 30 through the bypass path may be referred to as a temporary connection to be distinguished from the connection made via the GFDI 750.

Meanwhile, by temporarily connecting the power device 10 and the power system 30, the semiconductor circuit breaker 700 may determine whether the power device 10 and the power system 30 are normally connected, i.e., whether an abnormal current is flowing, based on the current flowing through the ground line. The semiconductor circuit breaker 700 may transmit a result of whether a normal connection has been made to the management system 200, based on a result of determining whether the abnormal current has been detected through the temporary connection. To transmit the result of the normal connection state determination, the semiconductor circuit breaker 700 may further include a communication unit 740 that is controlled by the controller 730 and performs a wireless or wired communication connection with the management system 200.

Here, the management system 200 may be a system for managing abnormal current detection results received from the semiconductor circuit breaker 700. For example, the management system 200 may be a power management system (PMS). The management system 200 may detect that an abnormal current has occurred from the power device 10 based on the abnormal current detection information received from the GFDI 750 of the abnormal current detection apparatus 701 according to this embodiment of the disclosure. The management system 200 may receive the result of determining whether an abnormal current exists from the semiconductor circuit breaker 700 of the abnormal current detection apparatus 701 according to this embodiment of the disclosure, and detect whether an abnormal current exists between the power device 10 and the power system 30 (whether an abnormal current exists). The management system 200 may control the display unit 300 to output the received result of determining whether the abnormal current exists, so that the operator can easily identify the existence or absence of the abnormal current.

Meanwhile, the semiconductor circuit breaker 700 which is in an inactive state may be activated according to the operating state of the GFDI 750. That is, as shown in FIG. 7, the abnormal current detection apparatus 701 according to this embodiment of the disclosure may include the semiconductor circuit breaker 700 and the GFDI 750 which are connected to each other, and may be configured so that the controller 730 of the semiconductor circuit breaker 700 receives abnormal current detection information detected by the GFDI 750.

In case of a normal state, that is, when a current in a normal range, for example, a current less than a preset fuse blowing current, flows through the poles of the fuse of the GFDI 750, the semiconductor circuit breaker 700 may be switched to an inactive state and maintained in the inactive state.

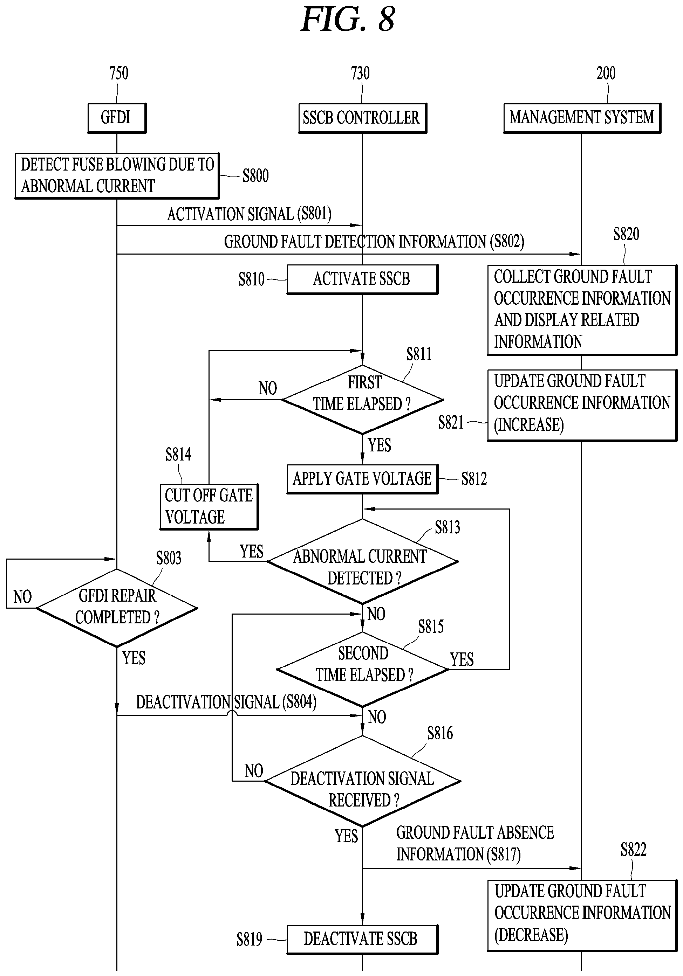

FIG. 8 is a flowchart of an example in which the abnormal current detection apparatus 701 according to an embodiment of the disclosure detects an abnormal current, namely, an operation process of detecting a ground fault current and determining presence or absence of a ground fault current.

Referring to FIG. 8, first, the GFDI 750 of the abnormal current detection apparatus 701 according to an embodiment of the disclosure may detect whether the fuse has blown by a flowing current (S800). When the fuse has blown due to the flow of an abnormal current exceeding a preset magnitude, the GFDI 750 may detect the fuse blowing, transmit an activation signal to the controller 730 of the semiconductor circuit breaker 700 (S801), and transmit abnormal current detection information (e.g., ground fault detection information) to notify the management system 200 that the abnormal current has occurred (S802). Here, the activation signal may be the abnormal current detection information.

That is, when an abnormal current is detected, the GFDI 750 may transmit abnormal current detection information to the management system 200 and the semiconductor circuit breaker 700, and the semiconductor circuit breaker 700 which receives the abnormal current detection information may be switched to an active state. For convenience of explanation, it is assumed that a ground fault current is detected, and thus the following description will be given under assumption that the abnormal current detection information is ground fault current detection information.

Then, the controller 730 of the semiconductor circuit breaker 700 may be switched from an inactive state to an active state (S810). Here, the inactive state is a state in which the semiconductor circuit breaker 700 is maintained at a minimum power state in which it can receive the activation signal, and may also be referred to as a sleep state or power-saving state.

The active state may mean a state in which the semiconductor circuit breaker 700 detects a current flowing into the semiconductor switch 710, determines whether the detected current is an overcurrent exceeding a preset magnitude, and controls the electrical connection between the source terminal and the drain terminal of the semiconductor switch 710 according to a result of the determination.

When the semiconductor circuit breaker 700 is activated, the controller 730 may check whether a preset first time has elapsed (S811). When the preset first time has elapsed, the controller 730 may apply a gate voltage higher than or equal to a threshold voltage so that the source terminal and the drain terminal of the semiconductor switch 710 are electrically connected (S812). Then, a bypass path which passes through the semiconductor switch 710, namely, connects the neutral line and the ground by bypassing the GFDI 750 in which the fuse has blown, may be formed. Accordingly, a current flowing in the neutral line (e.g., return current) may flow into the semiconductor switch 710.

Then, the controller 730 may detect whether the current flowing in the neutral line, which is introduced into the semiconductor switch 710, is an abnormal current, such as a short-circuit current or a leakage current (S813). For example, the controller 730 may determine that an abnormal current is flowing in the neutral line when the current of the neutral line, introduced into the semiconductor switch 710, is an overcurrent exceeding a preset current magnitude.

As a result of the determination in step S813, when the current flowing in the neutral line is the abnormal current, the controller 730 may control the gate driver 711 to apply a voltage lower than the preset threshold voltage to the gate terminal of the semiconductor switch 710 (S814). Accordingly, the electrical connection between the source terminal and the drain terminal of the semiconductor switch 710 can be cut off, and thus the bypass path can be blocked. As the fuse of the GFDI 750 blows and the bypass path is blocked, the power device 10 connected through the neutral line can be disconnected from the power system 30.

Then, the controller 730 may proceed to step S811 again to check whether the first time has elapsed. As a result of the check in step S811, when the first time has elapsed, the controller 730 may perform the process from step S812 to step S813 again.

On the other hand, as the result of the determination in step S813, when no abnormal current is not detected, the controller 730 may determine that the power device 10 is normally connected to the power system 30 through repair and the like. Then, the controller 730 may maintain a state in which the gate voltage higher than or equal to the threshold voltage is applied to the gate terminal.

Here, the controller 730 may check whether a preset second time has elapsed while the gate voltage higher than or equal to the threshold voltage is applied to the gate terminal (S815). When the second time has elapsed while the gate voltage higher than or equal to the threshold voltage is applied to the gate terminal, the controller 730 may proceed to step S813 again to re-determine whether the current of the neutral line, introduced into the semiconductor switch 710, is an abnormal current. That is, when the second time has elapsed even though no abnormal current is detected, the controller 730 may re-determine the presence or absence of the abnormal current from the neutral line where the abnormal current was detected.

When an abnormal current is detected again as a result of the determination in step S813, the controller 730 may proceed to step S814 to control the gate driver 711 to apply the gate voltage lower than the threshold voltage again, and proceed to step S811 to perform the process from step S811 to step S813.

Accordingly, until the semiconductor circuit breaker 700 receives the activation signal, the connection between the power device 10 and the power system 30 can be suppressed when a ground fault is temporarily undetected in a state where a ground fault has not been repaired.

When the second time has not elapsed as the result of the check in step S815, the controller 730 may check whether a deactivation signal has been received from the GFDI 750 (S816).

The GFDI 750 may determine whether the fuse connection has been restored through replacement (S803). For example, after the electrical connection between opposite poles of the fuse is cut off due to a fuse blow, when the electrical connection between the opposite poles is re-established, the GFDI 750 may determine that the fuse has been restored. When the electrical connection between the opposite poles of the fuse is re-established, the GFDI 750 may transmit a deactivation signal to the semiconductor circuit breaker 700 (S804). Here, the deactivation signal may be a signal notifying that the GFDI 750 can operate normally by replacing the blown fuse.

In step S804, when the deactivation signal is transmitted from the GFDI 750, the semiconductor circuit breaker 700 may confirm the reception of the deactivation signal in step S816. The controller 730 may then transmit, to the management system 200, information (e.g., information on absence of a ground fault) indicating that there is no abnormal current in the connection between the power device 10 and the power system 30 (S817). The controller 730 may switch the state of the semiconductor circuit breaker 700 into an inactive state.

Accordingly, the semiconductor circuit breaker 700 of the abnormal current detection apparatus 701 according to this embodiment of the disclosure can be activated based on ground fault detection information received from the GFDI 750 in the inactive state, and can be deactivated based on a normal operation signal received from the GFDI 750. That is, the semiconductor circuit breaker 700 of the abnormal current detection apparatus 701 according to the embodiment of the disclosure can be switched between the active state and the inactive state in conjunction with the operation state of the GFDI 750.

The management system 200 may receive the ground fault detection information received from the GFDI 750 in step S802. The management system 200 may search for the received ground fault detection information and information related to the power device 10 connected to the GFDI 750, which has transmitted the ground fault detection information, namely, the abnormal current detection apparatus 701 according to the embodiment of the disclosure. The management system 200 may display the searched information related to the power device 10 on the display unit 300 as information related to the detected ground fault. The management system 200 may manage information related to the power device 10 according to the received ground fault detection information.

For example, the management system 200 may update the status of the power device 10 connected to the abnormal current detection apparatus 701, in which the abnormal current has been detected, to an abnormal state (S821). In this case, when the management system 200 manages whether a plurality of power devices have a ground fault, the number of power devices in which a ground fault has been detected may increase.

The management system 200 may re-update information related to the power devices based on information received from the abnormal current detection apparatus 701 according to the embodiment of the disclosure. For example, the abnormal current absence information (e.g., ground fault absence information) received from the semiconductor circuit breaker 700 of the abnormal current detection apparatus 701 in step S817 may be received from the semiconductor circuit breaker 700 when the current of the neutral line connected to the power device 10 by the controller 730 of the semiconductor circuit breaker 700 is a normal current, and the controller 730 of the semiconductor circuit breaker 700 receives the deactivation signal from the GFDI 750 by virtue of the replacement of the blown fuse of the GFDI 750. Accordingly, when the abnormal current absence information is received from the semiconductor circuit breaker 700 of the abnormal current detection apparatus 701 in step S817, the management system 200 may determine that the cause of the abnormal current occurring in the power device 10 has been repaired.

The management system 200 may re-update the information related to the power devices based on the received abnormal current absence information (S822). In this case, the management system 200 may search for a power device 10 related to the received abnormal current detection information (e.g., the ground fault detection information) and change the state of the searched power device 10 from an abnormal state (e.g., a ground fault state) to a normal state. The management system 200 may control the display unit 300 to display information indicating the updated status of the power device 10.

Meanwhile, although not shown in FIG. 8, it goes without saying that the controller 730 of the semiconductor circuit breaker 700 according to the embodiment of the disclosure may control the communication unit 740 to transmit information on whether an abnormal current has been detected to the display unit 300. For example, when a request for information on whether an abnormal current has been detected is received through the display unit 300 connected to the communication unit 740, the controller 730 may transmit the information on whether the abnormal current has been detected, in response to the request. That is, even before receiving the deactivation signal and transmitting the abnormal current absence information, the controller 730 may transmit the result of determining whether the abnormal current has been detected in step S813 to the display unit 300, in response to the request for whether or not the abnormal current has been detected.

Alternatively, although not described in FIG. 8, the controller 730 of the semiconductor circuit breaker 700 according to the embodiment of the disclosure may transmit information indicating that the abnormal current has not been detected to the management system 200 even before the deactivation signal is received, when the abnormal current has not been detected as the result of the abnormal current detection in step S813 of FIG. 8. Then, the management system 200 may display through the display unit 300 that no abnormal current is detected in the corresponding power device based on the received information. Accordingly, the operator can perform a task, such as replacing the GFDI 750, only for a power device in which the abnormal current has not been detected, for example, a power devices in which a ground fault has been repaired, by checking the indication output through the display unit 300. Therefore, safety accidents for the operator can be suppressed.

The foregoing description has been given of the example in which the abnormal current detection apparatus 701 according to the embodiment of the disclosure determines that a ground fault has occurred when the current flowing in the neutral line exceeds a preset current magnitude, but it is obvious that the disclosure is not limited thereto. That is, as described above, the disclosure can detect not only whether an overcurrent is detected but also whether an abnormal current exists in another way, and can cut off the connection between the power device 10 and the power system 30 when the abnormal current is detected.

For example, the GFDI 750 may detect whether a ground fault has occurred based on the blowing of the fuse, and thus, there is a possibility that the GFDI 750 determines a noisy overcurrent or inrush current, which occurs temporarily and then is restored to a normal current, as an overcurrent caused by the ground fault. Accordingly, the abnormal current detection apparatus 701 according to the embodiment of the disclosure may determine whether a current detected from the neutral line meets a preset abnormal current condition, to suppress the power device 10 from being disconnected from the power system 30 by misidentifying the temporary overcurrent, such as the noisy overcurrent or inrush current occurs, as a fault overcurrent.

Only when the detected current meets the preset abnormal current condition, the semiconductor circuit breaker 700 can connect the ground and the neutral line through the semiconductor switch 710 to maintain the connection between the power device 10 and the power system 30. In this case, even though the fuse blows by the GFDI 750 due to the noisy overcurrent or inrush current, the connection between the power device 10 and the power system 30 can be maintained through the bypass path passing through the semiconductor switch 710.

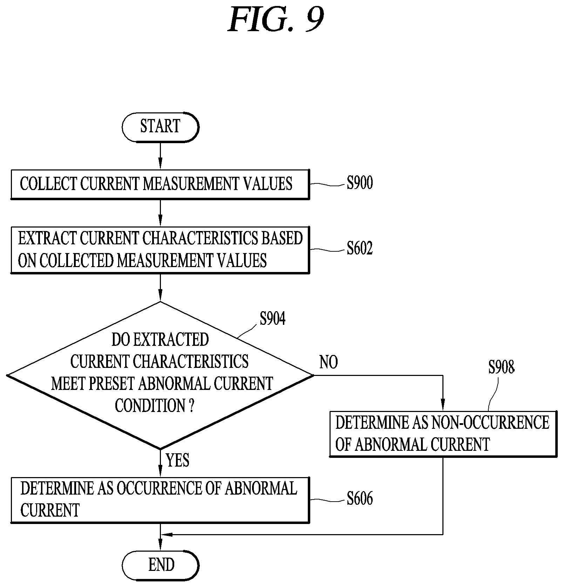

FIG. 9 is a flowchart of the operation process of step S13 of FIG. 8, in which the controller 730 of the semiconductor circuit breaker 700 of the abnormal current detection apparatus 701 according to the embodiment of the disclosure determines whether an abnormal current is flowing based on a result of current detection.

Referring to FIG. 9, when an activation signal is received from the GFDI 750 due to the detection of the fuse blow, the semiconductor circuit breaker 700 may form a bypass path connecting the neutral line and the ground by bypassing the GFDI 750. Currents of the neutral line introduced through the bypass path may be measured for a predetermined period of time, thereby collecting measurement values (S900). Current characteristics may be extracted from the collected measurement values (S902).

Here, the current characteristics may be calculated based on statistics on current magnitude, such as minimum current magnitude or maximum current magnitude and average current magnitude. Alternatively, the current characteristics may include not only the magnitude but also an amount of change in current magnitude over time (e.g., a slope of the current change over time).

When the current characteristics are extracted in step S902, the controller 730 may determine whether the extracted current characteristics satisfy a preset abnormal current condition (S904). Here, the preset abnormal current condition may be a condition set according to a prestored abnormal current profile. Here, the abnormal current profile may be prestored in the abnormal current detection apparatus 701 according to the embodiment of the disclosure, or may be transmitted to each abnormal current detection apparatus from the management system 200.

The controller 730 may compare the current characteristics extracted from the collected measurement values with current characteristics according to the abnormal current profile. As a result of the comparison, only when the extracted current characteristics match the characteristics according to the abnormal current profile by a preset level or more, the controller 730 may determine that the extracted current characteristics indicate an abnormal current that satisfies the preset condition.

For example, the abnormal current profile may include the following information: the change in current magnitude over time (e.g., a slope of change in current magnitude over time), an average current magnitude, a difference between maximum current value and minimum current value, and the like.

In this case, the controller 730 may determine that an abnormal current has occurred when the current characteristics detected according to the current measurement values, for example, the change in current magnitude over time, satisfies the condition according to the change in current magnitude over time according to the preset abnormal current profile. Alternatively, the controller 730 may determine that an abnormal current has occurred when the average current magnitude or the difference between the maximum current value and the minimum current value is greater than or equal to an average current magnitude or the difference between the maximum and minimum values according to the preset abnormal current profile(S906). Then, the controller 730 may proceed to step S814 of FIG. 8 to cut off the gate voltage, and proceed to step S811 of FIG. 8 to check whether the first time has elapsed. When the first time has elapsed, the controller 730 may proceed to steps after step S811.

On the other hand, when the current characteristics extracted according to the current measurement values do not match those of the abnormal current profile, the controller 730 may determine that no abnormal current has occurred(S908). The controller 730 may control the gate driver 711 to apply a gate voltage higher than or equal to the threshold voltage until the second time elapses in step S815 of FIG. 8 or until the deactivation signal is received from the GFDI 750 as the result of the detection in step S816 of FIG. 8. Accordingly, the bypass path connecting the neutral line and the ground can be maintained.

Therefore, even when the fuse of the GFDI 750 blows due to a temporarily occurring noisy overcurrent, the abnormal current detection apparatus 701 according to the embodiment of the disclosure can maintain the connection between the power device 10 and the power system 30 through the bypass path based on the abnormal current determination result. Therefore, the power device 10 can be operated normally.

The management system 200 that has received the abnormal current detection information from the GFDI 750 may display an abnormal state, thereby allowing the operator to perform replacement of the GFDI 750.

As described above, in the disclosure, the arranged semiconductor circuit breaker 700 can form the bypass path between the neutral line and the ground, such that the current of the neutral line can flow to the ground via the semiconductor switch 710, and determine whether an abnormal current, such as a leakage current, a short-circuit current, or a ground fault current, is flowing based on the state of the current flowing via the semiconductor switch 710.

Accordingly, in the case of the abnormal current detection apparatus 701 according to the embodiment of the disclosure, when a ground fault exists between the power device 10 and the power system 30, an overcurrent due to the ground fault may flow into the semiconductor switch 710. In this case, to suppress damage to the semiconductor switch 710 and safety accidents due to the inflow of an overcurrent, the controller 730 may limit the maximum amount of current which can flow through the semiconductor switch 710.

For example, the semiconductor switch 710 may determine the maximum amount of current which can flow from the source terminal to the drain terminal depending on the magnitude of a gate voltage. Accordingly, the controller 730 may limit the gate voltage applied to the gate terminal to a magnitude in a certain range from a threshold voltage. In this case, the magnitude of the current flowing in the bypass path via the semiconductor switch 710 can be limited, and an abnormal current profile for determining the abnormal current can be determined according to the magnitude of the gate voltage.

Meanwhile, in a state where the presence or absence of an abnormal current is not detected, the controller 730 may limit the magnitude of the current flowing from the neutral line to the ground via the semiconductor switch 710. However, in the case where the abnormal current is not detected, for example, when a ground fault has been repaired, the magnitude of the current output from the semiconductor switch 710 may not be limited. That is, by applying a gate voltage of a normal magnitude to the gate terminal, the controller 730 may not limit the magnitude of the current flowing in the bypass path.

Accordingly, when the gate voltage of the normal magnitude is called a reference gate voltage and the limited gate voltage applied to the gate terminal to detect the presence or absence of the abnormal current is called a test voltage, both the reference gate voltage and the test voltage may be voltages higher than or equal to the threshold voltage, but the test voltage may be a voltage lower than the reference gate voltage.

The foregoing description has been given of an example in which one power device 10 is connected to the power system 30, and the abnormal current detection apparatus 100 according to the embodiment of the disclosure includes the GFDI 750 and the semiconductor circuit breaker 700 between the one power device 10 and the power system 30. However, a plurality of power devices may be connected to the power system 30, and in this case, the abnormal current detection apparatus 701 according to the embodiment of the disclosure may be arranged between each power device and the power system.

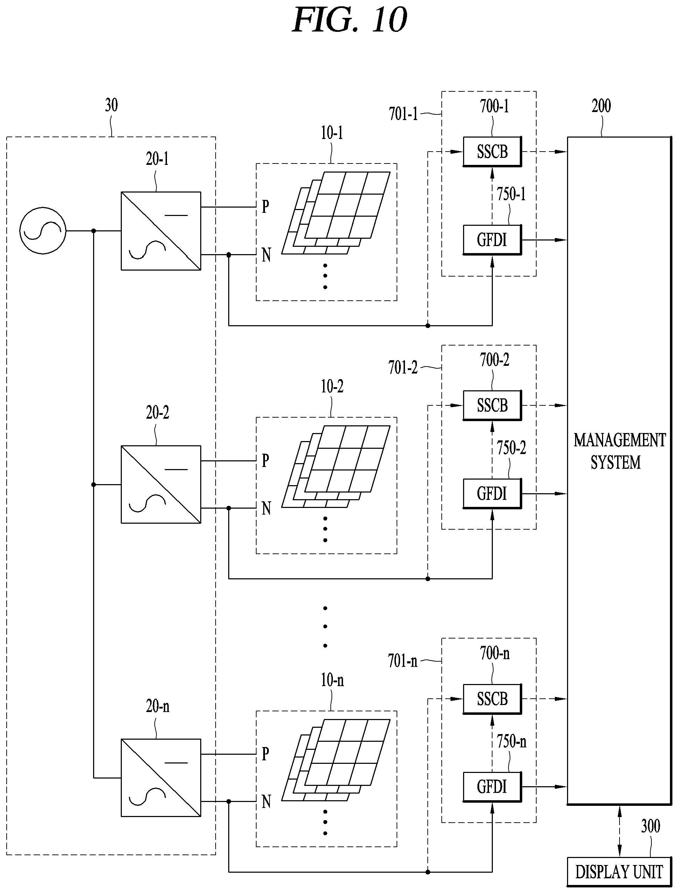

FIG. 10 is a view of an example of a power system connected to a plurality of power devices, and abnormal current detection apparatuses according to an embodiment, which are arranged between the plurality of power devices and the power system.

Referring to FIG. 10, a power system 30 including a plurality of converters 20-1, 20-2, ..., 20-n may be connected to a plurality of power devices 10-1, 10-2, ..., 10-n. In this case, abnormal current detection apparatuses 701-1, 701-2, ..., 701-n according to the embodiment of the disclosure may be arranged between the respective power devices and the power system 30.

Here, each of the abnormal current detection apparatuses according to the embodiment of the disclosure may be connected between the ground and a neutral line among lines which connect the power device and the power system. In more detail, GFDIs 750-1, 750-2, ..., 750-n of the corresponding abnormal current detection apparatuses may be connected between the corresponding neutral lines and ground, and the semiconductor circuit breakers 700-1, 700-2, ..., 700-n connected to the neutral lines may be connected to the ground by bypassing the corresponding GFDIs 750-1, 750-2, ..., and 750-n, thereby forming bypass paths. The GFDIs 750-1, 750-2, ..., and 750-n of the abnormal current detection apparatuses 701-1, 701-2, ..., and 701-n and the semiconductor circuit breakers 700-1, 700-2, ..., and 700-n may each be connected to the management system 200. The management system 200 may be connected to the display unit 300.

In this case, the GFDIs 750-1, 750-2, ..., 750-n which are connected to the corresponding neutral lines connecting the respective power devices 10-1, 10-2, ..., 10-n and the power system 30 may primarily determine whether an abnormal current flows between each power device 10 and the power system 30. Based on the fuse blow detection result of each GFDI, information on the occurrence of the abnormal current may be provided to the management system 200. The management system 200 may collect information related to a power device, in which an abnormal current has occurred, among the power devices 10-1, 10-2, ..., 10-n, based on information (abnormal current detection information) received from the GFDI connected to the power device in which the abnormal current has occurred.

The semiconductor circuit breaker of the abnormal current detection apparatus connected to the power device where the abnormal current has occurred may be activated based on the abnormal current detection information. Then, the semiconductor circuit breaker may form a bypass path, which connects the neutral line and ground of the power device by bypassing the GFDI, by applying a preset gate voltage to the gate terminal, and detect a current flowing in the formed bypass path. The semiconductor circuit breaker may determine according to a result of the detection whether an abnormal current is flowing in the neutral line.

When the determination result shows that no abnormal current is detected, each semiconductor circuit breaker may transmit information indicating that no abnormal current is detected to the management system 200. Then, the management system 200 may distinctively display information related to a power device, in which the abnormal current is not detected any more, among power devices in which the abnormal current has been detected, on the display unit 300. Therefore, even when the plurality of power devices are connected, a power device in which an abnormal current is occurring can be easily identified and distinguished.

Meanwhile, the foregoing description of the disclosure has been given of the detailed embodiment, but various modifications may be made without departing from the scope of the disclosure. In particular, in the embodiment of the disclosure, the configuration in which the display unit 300 is controlled by the management system 200 has been described, but it is of course possible that the display unit 300 may be controlled directly from the abnormal current detection apparatus 701 according to the embodiment of the disclosure.

For example, an operator may request information on whether a target power device is operating normally from the abnormal current detection apparatus according to the embodiment of the disclosure, which is connected to the target power device, and the abnormal current detection apparatus may provide information on whether the target power device is operating normally in response to the request. In this case, information on whether the power device is operating normally may be provided to the operator without going through the management system.

The above description shows the configuration in which the abnormal current detection apparatus according to the embodiment of the disclosure including the GFDI 750 and the semiconductor circuit breaker 700 that are driven separately from each other. However, this is only an embodiment of the disclosure, and it is obvious that the disclosure is not limited thereto.

For example, the controller 730 of the semiconductor circuit breaker 700 may be a controller which controls the overall operation of the abnormal current detection apparatus according to the embodiment of the disclosure. In this case, the GFDI and the semiconductor switch may be operated by the controller. That is, the GFDI may transmit to the controller whether the fuse has blown or not.

Then, the controller may control the communication unit so that ground fault detection information can be transmitted to the management system 200. The controller may activate the semiconductor switch and apply a voltage higher than or equal to a threshold voltage to the gate terminal of the semiconductor switch to form the bypass path that bypasses the GFDI.

Through the operation process described in FIG. 8, the controller may determine whether the current of the neutral line flowing through the bypass path is an abnormal current and provide a result of the determination to the management system 200.

When the blown fuse of the GFDI is replaced and a current flows through the opposite poles of the GFDI fuse, the GFDI may transmit the current flow result to the controller 730. Then, the controller 730 may deactivate the semiconductor switch based on the information received from the GFDI.

Accordingly, the electrical connection between the source terminal and the drain terminal of the semiconductor switch can be cut off, so that the bypass path can be cut off. Therefore, the current of the neutral line can be grounded via the GFDI.

When the semiconductor switch is deactivated, the controller 730 may notify the management system 200 that the ground fault state detected from the power device has been resolved by transmitting the ground fault absence information to the management system.

The above description assumes the configuration in which the current detection unit is connected between the neutral line and the ground, but it is of course possible that the neutral line of the power device and the power system is connected via the current detection unit.

In this case, assuming that the current detection unit is the GFDI as described above, a first pole of the fuse of the GFDI may be connected to an N pole of the power system, and a second pole of the fuse of the GFDI may be connected to an N pole of the power device. In this case, the neutral line connecting the second pole and the N pole of the power device may be connected to the ground.

The disclosure can be implemented as computer-readable codes in a program-recorded medium. The computer-readable medium may include all types of recording devices each storing data readable by a computer system. Examples of the computer-readable medium include a hard disk drive (HDD), a solid state disk (SSD), a silicon disk drive (SDD), a ROM, a RAM, a CD-ROM, a magnetic tape, a floppy disk, an optical data storage device and the like, and may also be implemented in the form of a carrier wave (e.g., transmission over the Internet). The computer may include the controller of the semiconductor circuit breaker. Therefore, the detailed description should not be limitedly construed in all of the aspects, and should be understood to be illustrative. Therefore, all changes and modifications that fall within the metes and bounds of the claims, or equivalents of such metes and bounds are therefore intended to be embraced by the appended claims.

## Claims

1. An abnormal current detection apparatus comprising:
a semiconductor switch connected to any one of a plurality of lines connecting a power system and a power device, such that the power system is connected to the power device;
a gate driver configured to apply a gate voltage to the semiconductor switch; and
a controller configured to determine whether a ground fault current exists based on a current flowing into the semiconductor switch between the connected power system and power device, and control the gate driver to disconnect the power device from the power system according to a result of the determination,
wherein the controller, when the power device is disconnected from the power system, redetermines whether the ground fault current exists based on the current flowing into the semiconductor switch by controlling the gate driver such that the power device is connected to the power system at a preset time interval, and controls the gate driver, according to a result of the redetermination, to disconnect the power device from the power system again or maintain the connected state between the power device and the power system.

2. The abnormal current detection apparatus of claim 1, wherein the one of the plurality of lines is a neutral line connecting the power device and the power system,
the neutral line is connected to ground, and
a source terminal of the semiconductor switch is connected to the neutral line and a drain terminal of the semiconductor switch is connected to the ground.

3. The abnormal current detection apparatus of claim 2, wherein the controller, when the power device is disconnected from the power system, redetermines whether the ground fault current exists by applying a gate voltage of a limited level to a gate terminal of the semiconductor switch at the preset time interval and temporarily connect the source terminal and the drain terminal, and
restores the gate voltage of the limited level when a ground fault current does not exist as a result of the redetermination.

4. The abnormal current detection apparatus of claim 3, wherein the gate voltage of the limited level is a voltage higher than or equal to a threshold voltage at which the source terminal and the drain terminal of the semiconductor switch are electrically connectable to each other, and
a voltage of a level lower than a level of the restored gate voltage.

5. The abnormal current detection apparatus of claim 1, wherein a management system connected to the abnormal current detection apparatus to perform communication transmits a reference current, for the abnormal current detection apparatus to redetermine whether the ground fault current exist, to the abnormal current detection apparatus based on a detection result of the ground fault current and ground fault detection information including information related to a power device in which the ground fault current has been detected, and
the abnormal current detection apparatus redetermines whether a ground fault current exists, based on a result of comparing a result of detecting the current, flowing to the semiconductor switch from the power device and the power system connected at the preset time interval, and the reference current.

6. The abnormal current detection apparatus of claim 5, wherein the controller compares a result of analyzing characteristics of the current flowing into the semiconductor switch with abnormal current characteristics according to a preset abnormal current profile, and determines or redetermines whether the ground fault current exists according to a result of determining whether current characteristics analyzed by a result of the comparison match the abnormal current characteristics, and
the abnormal current profile comprises at least one of a change in current magnitude over time, an average current magnitude, and a difference between a maximum current value and a minimum current value, and is provided from the management system.

7. A method of controlling an abnormal current detection apparatus comprising a semiconductor switch connected to one of a plurality of lines connecting a power system and a power device, the method comprising:
controlling the semiconductor switch to connect the power device to the power system;
detecting a current flowing between the connected power device and power system and primarily determining whether a ground fault current exists based on a preset ground fault detection current;
controlling the semiconductor switch to disconnect the power device from the power system according to a result of the primary determination;
checking whether a preset time has elapsed;
controlling the semiconductor switch to reconnect the power device to the power system when the preset time has elapsed as a result of the check;
detecting a current flowing between the reconnected power device and power system and secondarily determining whether the ground fault current exists based on a preset reference current; and
re-performing the check of whether the preset time has elapsed through the secondary determination, or maintaining a state where the power device is connected to the power system, according to a result of the secondary determination.

8. The abnormal current detection apparatus of claim 7, wherein the one of the plurality of lines is a neutral line connecting the power device and the power system,
the neutral line is connected to ground,
a source terminal of the semiconductor switch is connected to the neutral line and a drain terminal of the semiconductor switch is connected to the ground,
the controlling the semiconductor switch to connect the power device to the power system is a step of applying a first gate voltage higher than or equal to a preset threshold voltage to a gate terminal of the semiconductor switch so that the source terminal and the drain terminal of the semiconductor switch are electrically connected, and
the controlling the semiconductor switch to reconnect the power device to the power system is a step of applying a second gate voltage, which is higher than or equal to the threshold voltage and lower than the first gate voltage, to the gate terminal of the semiconductor switch.

9. An abnormal current detection apparatus comprising:
a current detection unit arranged on one of a plurality of lines connecting a power system and a power device so as to connect the power system and the power device, and configured to detect whether an abnormal current exists based on preset detection information, and to disconnect the power device from the power system according to a result of the detection of whether the abnormal current exists;
a semiconductor switch connected to the current detection unit to form a bypass path bypassing the current detection unit, and comprising a gate driver configured to apply a gate voltage for controlling a first terminal and a second terminal, connected to a first pole and a second pole of the current detection unit, respectively, for forming the bypass path, to be electrically connected or electrically disconnected; and
a controller configured to control the first terminal and the second terminal to be electrically connected when the power device is disconnected from the power system according to whether the current detection unit has detected an abnormal current, determine whether the abnormal current exists based on a current flowing along the bypass path through the connected first terminal and second terminal, and control the semiconductor switch to cut off the bypass path or maintain the connection between the power system and the power device through the bypass path according to a result of the determination.

10. The abnormal current detection apparatus of claim 9, wherein the current detection unit is a ground fault detection indicator (GFDI) comprising a fuse that blows when an overcurrent higher than or equal to a preset blowing current is introduced, and
the fuse is connected between ground and a neutral line among the plurality of lines connecting the power system and the power device.

11. The abnormal current detection apparatus of claim 10, wherein a first pole of the fuse is connected to the neutral wire, and a second pole of the fuse is connected to the ground, and
the first terminal of the semiconductor switch is connected between the first pole of the fuse and the neutral line, and the second terminal of the semiconductor switch is connected between the second pole of the fuse and the ground.

12. The abnormal current detection apparatus of claim 10, wherein the controller
activates the semiconductor switch in an inactive state in conjunction with blowing of the fuse, and
the controller switches the semiconductor switch in an active state into the inactive state when the blown fuse is replaced and the first and second poles of the fuse are electrically connected.

13. The abnormal current detection apparatus of claim 9, wherein the controller
controls the semiconductor switch to apply a first gate voltage exceeding a preset threshold voltage so as to form a first bypass path, and determines whether the abnormal current exists through the formed first bypass path, and
when a result of the determination shows that no abnormal current exists, controls the semiconductor switch to apply a second gate voltage higher than the first gate voltage, so as to form a second bypass path for maintaining the connection between the power system and the power device.

14. An abnormal current detection apparatus comprising;
a current detection unit configured to connect ground and a neutral line among lines connecting a power system and a power device, detect an abnormal current flowing in the neutral line, and disconnect the power device from the power system when the abnormal current is detected; and
a semiconductor circuit breaker (solid state circuit breaker (SSCB)) comprising a semiconductor switch connected to the current detection unit to receive a result of the abnormal current detection provided from the current detection unit, and configured to form a bypass path connecting the neutral line and the ground by bypassing the current detection unit when the abnormal current is detected from the current detection unit and thereby the power device is disconnected from the power system, and a controller configured to determining whether the abnormal current flows on the neutral line based on a current flowing in the bypass path, and control the semiconductor switch to cut off the bypass path or maintain the connection between the neutral line and the ground through the bypass path according to a result of the determination.

15. The abnormal current detection apparatus of claim 14, wherein the current detection unit is a ground fault detection indicator (GFDI) comprising a fuse that blows when an abnormal current exceeding a preset blowing current is detected,
the GFDI transmits abnormal current detection information to a management system and the semiconductor circuit breaker according to blowing of the fuse, and
the semiconductor circuit breaker is switched from an inactive state to an active state when the abnormal current detection information is received.

16. The abnormal current detection apparatus of claim 15, wherein the GFDI transmits a deactivation signal to the semiconductor circuit breaker when the neutral line and the ground are connected through the fuse as the blown fuse is replaced, and
the semiconductor circuit breaker is switched from the active state to the inactive state when the deactivation signal is received, and transmits information indicating that the power device has been normally connected to the management system.
